# EUROPEAN PATENT APPLICATION

(11) **EP 4 750 287 A1**
(43) Date of publication of application: **27.05.2026**
(21) Application number: 24845562.8
(22) Date of filing: 19.07.2024
(51) Int. Cl.: H10K 50/828, B32B 9/00, G09F 9/30, H10K 50/17, H10K 50/826, H10K 59/10, H10K 71/10, H10K 71/60, H10K 102/10, H10K 102/20

(54) **THIN FILM-MODIFIED ELECTRODE AND ORGANIC ELEMENT USING SAME**

(30) Priority: 21.07.2023 JP 2023119245; 29.02.2024 JP 2024030553
(71) Applicant: Nippon Shokubai Co., Ltd., Osaka-shi, Osaka 541-0043 (JP); Nippon Hoso Kyokai, Tokyo 150-8001 (JP)
(72) Inventor: KUWADA, Kenji, Suita-shi, Osaka 564-0034 (JP); KOBAYASHI, Naoki, Suita-shi, Osaka 564-0034 (JP); HASEGAWA, Munehiro, Suita-shi, Osaka 564-0034 (JP); GOYA, Tsuyoshi, Suita-shi, Osaka 564-0034 (JP); MORII, Katsuyuki, Suita-shi, Osaka 564-0034 (JP); FUKAGAWA, Hirohiko, Tokyo 157-8510 (JP); OONO, Taku, Tokyo 157-8510 (JP); SASAKI, Tsubasa, Tokyo 157-8510 (JP); OKADA, Takuya, Tokyo 157-8510 (JP); SHIMIZU, Takahisa, Tokyo 157-8510 (JP)
(74) Representative: Cabinet Beau de Loménie
(86) International application number: PCT/JP2024/025999
(87) International publication number: WO 2025/023185

(57) **Abstract**

Provided is an electrode particularly excellent in air stability and electron injection properties, and an organic device including the electrode. The present invention relates to a thin film-modified electrode including: an electrode; and a layer containing at least one metal and an organic compound capable of coordinating to the at least one metal, the layer being in contact with the electrode, or both a layer containing at least one metal, the layer being in contact with the electrode, and a layer containing an organic compound capable of coordinating to the at least one metal, the layer being in contact with the layer containing at least one metal, the organic compound being a compound containing atoms capable of coordinating to metal and having a sum of distances from the atoms capable of coordinating to metal in the organic compound to an aluminum atom of 4.06 Å or less, as determined from a structure optimized by density functional theory calculations, where the aluminum atom is set as the metal, using functional: B3LYP/basis set: 6-31G**.

## Description

### TECHNICAL FIELD

The present invention relates to thin film-modified electrodes and organic devices including the same.

### BACKGROUND ART

Organic electroluminescent devices are thin, soft, and flexible, and displays including organic electroluminescent devices can display higher-lum inance, higher-definition images than currently dominant liquid crystal displays and plasma displays. Since displays including organic electroluminescent devices have a wider viewing angle than liquid crystal displays, their use as, for example, displays for televisions and mobile phones is expected to expand further in the future, and they are also expected to be used as lighting systems.

Organic devices such as organic electroluminescent devices, organic thin-film solar cells, and organic thin-film transistors have a structure in which an organic thin film is formed between two electrodes. In these organic devices, charge transfer between each electrode and the organic thin film is necessary, and hole injection materials and electron injection materials to be used between each electrode and the organic thin film have been intensively studied. Alkali metals have been widely used as materials for injecting electrons into organic thin films. An electron injection layer including an alkali metal as a material, which has extremely low moisture resistance, hardly stably operates for a long period of time on a flexible substrate that is prone to moisture penetration. To overcome such problems, development of electron injection layers not including alkali metals has been progressing, and recently, an organic electroluminescence device including polyethylenimine or a polyethylenimine-modified compound has been reported as a coatable electron injection layer material containing an organic compound (Non-Patent Literatures 1 to 3). It has also been reported that electrons can be smoothly injected by utilizing coordination reactions between element(s) of the cathode and nitrogen-containing heterocyclic compounds such as pyridine and phenanthroline derivatives. For example, it has been reported that since a phenanthroline derivative, which contains nitrogen atoms, has a high coordination ability with metal ions to facilitate electron emission from the metal atoms and to greatly reduce electron injection barriers at the interface between an electrode and an organic layer, use of a phenanthroline derivative between an electrode and an organic layer can improve the electron injection ability (see Non-Patent Literatures 4 to 6).

### CITATION LIST

### - Non-Patent Literature

Non-Patent Literature 1: Tao Xiong and three others, "Applied Physics Letters", Vol. 93, 2008, pp. 123310-1
Non-Patent Literature 2: Yinhua Zhou and twenty-one others, "Science", Vol. 336, 2012, pp. 327
Non-Patent Literature 3: Jianshan Chen and six others, "Journal of Materials Chemistry", 2012, Vol. 22, pp. 5164
Non-Patent Literature 4: Hiroyuki Yoshida, "JOURNAL OF PHYSICAL CHEMISTRY" (J. Phys. Chem. C20151194324459-24464), Vol. 119, 2015, p. 24459
Non-Patent Literature 5: Zhengyang Bin and seven others, "Nature Communications", Vol. 10, 2019, p. 866
Non-Patent Literature 6: Hirohiko Fukagawa and eight others, "Nature Communications", Vol. 11, 2020, p. 1

### SUMMARY OF INVENTION

### - Technical Problem

Although many materials that exhibit coordination reactions with element(s) of the cathode, such as pyridine and phenanthroline derivatives, have been reported, as described above, no materials suitable for providing electrodes particularly excellent in air stability and electron injection properties or providing devices including such electrodes have yet been reported.

The present invention has been made in view of the above-mentioned current state of arts, and aims to provide an electrode particularly excellent in air stability and electron injection properties, and an organic device including the electrode.

### - Solution to Problem

The present inventors have investigated materials capable of providing electrodes particularly excellent in air stability and electron injection properties. They found that, as for an organic compound capable of coordinating to a metal and containing atoms capable of coordinating to metal, the sum of distances from the atoms capable of coordinating to metal in the organic compound to an aluminum atom determined by predetermined molecular orbital calculations, where the aluminum atom is set as a metal to be coordinated, has a correlation with the air stability and electron injection properties of an organic device actually produced using the organic compound. The present inventors also have found that a thin film-modified electrode excellent in electron injection properties can be obtained by forming, on an electrode, a layer containing an organic compound having the sum of distances of 4.06 Å or less and a metal or a multilayer including a layer containing the organic compound and a layer containing a metal. They also have found that an organic device including such a thin film-modified electrode is excellent in air stability and electron injection properties.

The present inventors also have found that there is a correlation between the equilibrium density calculated by molecular dynamics simulation for an organic compound and the air stability of an organic device actually produced using the organic compound. The present inventors also have found that an organic device excellent in air stability can be produced by forming, on an electrode, a layer containing an organic compound having an equilibrium density of 1.17 g/cm³ or more and a metal or a multilayer including a layer containing the organic compound and a layer containing a metal.

The present inventors have arrived at the present invention based on these findings.

The following specifically describes the present invention.
(1) A thin film-modified electrode containing:
   an electrode; and
   a layer containing at least one metal and an organic compound capable of coordinating to the at least one metal, the layer being in contact with the electrode, or
   both a layer containing at least one metal, the layer being in contact with the electrode, and a layer containing an organic compound capable of coordinating to the at least one metal, the layer being in contact with the layer containing at least one metal,
   the organic compound being a compound containing atoms capable of coordinating to metal and having a sum of distances from the atoms capable of coordinating to metal in the organic compound to an aluminum atom of 4.06 Å or less, as determined from a structure optimized by density functional theory calculations, where the aluminum atom is set as the metal, using functional: B3LYP/basis set: 6-31G**.
(2) The thin film-modified electrode according to (1),
   wherein the at least one metal comprises a metal having a work function of 4.0 eV or higher.
(3) A thin film-modified electrode containing:
   an electrode; and
   a layer containing at least one metal and an organic compound capable of coordinating to the at least one metal, the layer being in contact with the electrode, or
   both a layer containing at least one metal, the layer being in contact with the electrode, and a layer containing an organic compound capable of coordinating to the at least one metal, the layer being in contact with the layer containing at least one metal,
   the organic compound being a compound having an equilibrium density of intermolecular packing of 1.17 g/cm³ or more, as determined by molecular dynamics calculations from a structure optimized by density functional theory calculations using functional: B3LYP-D3/basis set: 6-31G**.
(4) The thin film-modified electrode according to (3),
   wherein the equilibrium density of the organic compound is 1.20 g/cm³ or more.
(5) The thin film-modified electrode according to any one of (1) to (4),
   wherein the at least one metal is at least one selected from the group consisting of aluminum, magnesium, and silver.
(6) The thin film-modified electrode according to any one of (1) to (5),
   wherein the atoms capable of coordinating to metal in the organic compound are selected from the group consisting of a nitrogen atom, a sulfur atom, and an oxygen atom.
(7) An organic device containing the thin film-modified electrode according to any one of (1) to (6).
(8) A lighting system containing the organic device according to (7).
(9) A display containing the organic device according to (7).
(10) A method of producing a thin film-modified electrode, including:
   a first step of selecting an organic compound capable of coordinating to a metal, the organic compound containing atoms capable of coordinating to metal and having a sum of distances from the atoms capable of coordinating to metal in the organic compound to an aluminum atom of 4.06 Å or less, as determined from a structure optimized for the organic compound by density functional theory calculations, where the aluminum atom is set as the metal, using functional: B3LYP/basis set: 6-31G**; and
   a second step including forming, using the organic compound selected in the first step and a metal, a layer containing the organic compound and the metal, the layer being in contact with an electrode, or forming sequentially a layer containing the metal, the layer being in contact with an electrode, and a layer containing the organic compound, the layer being in contact with the layer containing the metal.
(11) A method of producing a thin film-modified electrode, including:
   a first step of selecting an organic compound capable of coordinating to a metal, the organic compound having an equilibrium density of intermolecular packing of 1.17 g/cm³ or more, as determined by molecular dynamics calculations from a structure optimized for the organic compound by density functional theory calculations using functional: B3LYP-D3/basis set: 6-31G**; and
   a second step including forming, using the organic compound selected in the first step and a metal, a layer containing the organic compound and the metal, the layer being in contact with an electrode, or forming sequentially a layer containing the metal, the layer being in contact with an electrode, and a layer containing the organic compound, the layer being in contact with the layer containing the metal.
(12) A method of producing an organic device, including:
   producing a thin film-modified electrode by the method of producing a thin film-modified electrode according to (10) or (11); and
   forming an organic layer on the thin film-modified electrode.
(13) A method of selecting an organic compound suitable as a material used in combination with a metal to form an electron injection layer of an organic device,
   the method including selecting, as the material used in combination with a metal to form an electron injection layer of an organic device, an organic compound capable of coordinating to the metal, the organic compound containing atoms capable of coordinating to metal and having a sum of distances from the atoms capable of coordinating to metal in the organic compound to an aluminum atom of 4.06 Å or less, as determined from a structure optimized for the organic compound by density functional theory calculations, where the aluminum atom is set as the metal, using functional: B3LYP/basis set: 6-31G**.
(14) A method of selecting an organic compound suitable as a material used in combination with a metal to form an electron injection layer of an organic device,
   the method including selecting, as the material used in combination with a metal to form an electron injection layer of an organic device, an organic compound capable of coordinating to the metal, the organic compound having an equilibrium density of intermolecular packing of 1.17 g/cm³ or more, as determined by molecular dynamics calculations from a structure optimized for the organic compound by density functional theory calculations using functional: B3LYP-D3/basis set: 6-31G**.

### - Advantageous Effects of Invention

The present invention can provide a thin film-modified electrode particularly excellent in air stability and electron injection properties, and an organic device including the thin film-modified electrode.

The present invention can also provide a lighting system and a display each including the organic device, as well as a method of producing the thin film-modified electrode, a method of producing the organic device, and a method of selecting a material for an electron injection layer of the organic device.

The thin film-modified electrode of the present invention and the organic device including the thin film-modified electrode of the present invention are excellent in air stability and electron injection properties, and therefore can be suitably used as an organic electroluminescent device, an organic thin-film solar cell, an organic thin-film transistor, etc.

### BRIEF DESCRIPTION OF DRAWINGS

FIG. 1 is a schematic view of a multilayer structure of an organic device produced in the EXAMPLES.
FIG. 2 shows the measurement positions of a degraded area width w of an emitting surface of the organic device in the EXAMPLES.
FIG. 3 is a plot for Examples 1-1 to 1-3, Comparative Examples 1-1 and 1-2, Examples 4-1 to 4-3, and Comparative Examples 4-1 and 4-2, in which any one of Compounds 1 to 5 is used, the plot showing a relationship between a sum of distances from the atoms capable of coordinating to metal in the corresponding organic compound to an aluminum atom, determined by molecular orbital calculations for the organic compound, and a shrinkage growth rate α of an organic device produced using the organic compound.
FIG. 4 is a plot for Examples 1-1 to 1-3, Comparative Examples 1-1 and 1-2, Examples 4-1 to 4-3, and Comparative Examples 4-1 and 4-2, in which any one of Compounds 1 to 5 is used, the plot showing a relationship between a sum of distances from the atoms capable of coordinating to metal in the corresponding organic compound to an aluminum atom, determined by molecular orbital calculations for the organic compound, and a voltage at which the luminance of an organic device produced using the organic compounds is 100 nits.
FIG. 5 shows a ¹H-NMR spectrum of Compound 8 synthesized in Synthesis Example 3.
FIG. 6 shows a ¹H-NMR spectrum of Compound 9 synthesized in Synthesis Example 4.
FIG. 7 is a plot showing the relationship between the equilibrium density of intermolecular packing, determined by molecular dynamics calculations, for the organic compounds represented by the structural formulas (17) to (23) used in Examples 6 to 8 and Comparative Examples 5 to 8, and the shrinkage growth rate α of an organic device produced using any of the organic compounds.

### DESCRIPTION OF EMBODIMENTS

The present invention is described in detail below.

A combination of two or more of individual preferred embodiments of the present invention described below is also a preferred embodiment of the present invention.

The thin film-modified electrode of the present invention includes an electrode and a layer containing a metal and an organic compound capable of coordinating to the metal, the layer being in contact with the electrode, or both a layer containing a metal, the layer being in contact with the electrode, and a layer containing an organic compound capable of coordinating to the metal, the layer being in contact with the layer containing a metal. The organic compound used contains atoms capable of coordinating to metal and may be (1) a compound having a sum of distances from the atoms capable of coordinating to metal in the organic compound to an aluminum atom of 4.06 Å or less, as determined from a structure optimized by density functional theory calculations, where the aluminum atom is set as the metal, using functional: B3LYP/basis set: 6-31G**, or (2) a compound having an equilibrium density of intermolecular packing of 1.17 g/cm³ or more, as determined by molecular dynamics calculations from a structure optimized by density functional theory calculations using functional: B3LYP-D3/basis set: 6-31G**.

Hereinafter, the thin film-modified electrode produced using the organic compound described in (1) is referred to as a thin film-modified electrode of a first aspect of the present invention, the thin film-modified electrode produced using the organic compound described in (2) is referred to as a thin film-modified electrode of a second aspect of the present invention, and the thin film-modified electrodes of the first and second aspects of the present invention are collectively referred to as a thin film-modified electrode of the present invention.

### <Thin film-modified electrode of the first aspect of the present invention>

In the thin film-modified electrode of the first aspect of the present invention, the coordination reaction between a metal and an organic compound is utilized to improve the electron injection properties.

When an organic device is used in air, the emitting surface degrades over time. The relationship between the degraded area width of the emitting surface and the elapsed time can be approximated using a diffusion equation (see Takeru Okada, et al. (2017), Jpn. J. Appl. Phys. 56 060305), and from which the degradation (shrinkage) growth rate is determined. Thus, the air stability of the organic device can be evaluated.

As described in the below-described EXAMPLES, the shrinkage growth rates of organic devices produced using a plurality of organic compounds with different structures as compounds that each contain atoms capable of coordinating to metal have a correlation with the sum of distances from the atoms capable of coordinating to metal in the corresponding organic compound to an aluminum atom, as determined from a structure optimized by density functional theory calculations, where the aluminum atom is set as the metal, using functional: B3LYP/basis set: 6-31G**. This is considered to be because the coordination bond is less likely to be broken by moisture or air due to the short distance between the organic compound and the metal. Use of an organic compound having the sum of distances of 4.06 Å or less in combination with a metal to which the organic compound can coordinate can provide an organic device excellent in electron injection properties and air stability.

When the organic compound contains a plurality of atoms capable of coordinating to metal, the phrase "sum of distances from the atoms capable of coordinating to metal in the organic compound to an aluminum atom" refers to the sum of distances from the atoms to the metal atom.

### 1-1. Thin film-modified electrode of the first aspect of the present invention

The thin film-modified electrode of the first aspect of the present invention may include a layer containing a metal and an organic compound capable of coordinating to the metal and having the sum of distances of 4.06 Å or less, the layer being in contact with (in direct contact with) an electrode, or both a layer containing a metal, the layer being in contact with (in direct contact with) an electrode, and a layer containing an organic compound capable of coordinating to the metal and having the sum of distances of 4.06 Å or less, the layer being in contact with the layer containing a metal. Preferably, the thin film-modified electrode includes two layers consisting of a layer containing a metal, the layer being in contact with an electrode, and a layer containing the organic compound, the layer being in contact with the layer containing a metal (in other words, an electrode, a layer containing a metal, and a layer containing an organic compound capable of coordinating to the metal and having the sum of distances of 4.06 Å or less are sequentially formed, each being in contact with the next). In such a structure, the coordination reaction between the metal and the organic compound can be utilized more efficiently to improve the electron injection properties. In addition, the cleavage of the coordination bond by molecules such as water molecules or atmospheric oxygen molecules can be reduced owing to the strength of the bond.

When the thin film-modified electrode of the first aspect of the present invention includes a layer containing a metal, the layer being in contact with an electrode, and a layer containing an organic compound capable of coordinating to the metal and having the sum of distances of 4.06 Å or less, the layer being in contact with the layer containing a metal, the layer containing a metal may be a metal layer of a single metal element, a mixed metal layer of a single metal element and an oxide thereof in which a small amount of oxygen atoms are mixed, a multilayer including two or more layers selected from the group consisting of a layer of a mixture of two or more metal elements and a layer of a single metal element, a layer of a mixture of two or more metal elements, or a mixed layer of two or more metal elements and an oxide thereof in which a small amount of oxygen atoms are mixed.

When the thin film-modified electrode of the first aspect of the present invention includes a layer containing a metal, the layer being in contact with an electrode, and a layer containing an organic compound capable of coordinating to the metal and having the sum of distances of 4.06 Å or less, the layer being in contact with the layer containing a metal, the layer containing an organic compound may further contain an electron transport material described later.

When the thin film-modified electrode of the first aspect of the present invention includes a single layer containing a metal and an organic compound capable of coordinating to the metal and having the sum of distances of 4.06 Å or less, the layer being in contact with an electrode, the single layer containing a metal and an organic compound preferably has a thickness of 0.1 to 50 nm, more preferably 0.1 to 10 nm.

When the thin film-modified electrode of the first aspect of the present invention includes two layers consisting of a layer containing a metal, the layer being in contact with an electrode, and a layer containing an organic compound capable of coordinating to the metal and having the sum of distances of 4.06 Å or less, the layer being in contact with the layer containing a metal, the layer containing a metal preferably has a thickness of 0.1 to 5 nm, more preferably 0.5 to 2 nm.

The layer containing an organic compound capable of coordinating to the metal and having the sum of distances of 4.06 Å or less preferably has a thickness of 0.5 to 10 nm, more preferably 1 to 5 nm, still more preferably 1 to 3 nm.

The thickness of each layer can be measured using a stylus profiler, spectroscopic ellipsometry, or X-ray photoelectron spectroscopy.

The metal in the layer that is in contact with the electrode in the thin film-modified electrode of the first aspect of the present invention may be any metal to which an organic compound can coordinate, and preferably has a work function of 4.0 eV or higher. Use of such a metal allows the thin film-modified electrode to be stable in air and to exhibit excellent electron injection properties. The metal more preferably has a work function of 4.2 eV or higher, still more preferably a work function of 4.6 eV or higher.

In the thin film-modified electrode of the first aspect of the present invention, the metal in the layer that is in contact with the electrode is preferably at least one selected from the group consisting of aluminum, magnesium, silver, zinc, copper, nickel, palladium, platinum, gold, cobalt, chromium, manganese, iron, tin, indium, titanium, zirconium, vanadium, niobium, tantalum, molybdenum, tungsten, indium, gallium, and cadmium. Use of any of these metals allows the thin film-modified electrode to be further excellent in electron injection properties and air stability. Of these, at least one selected from the group consisting of aluminum, magnesium, silver, zinc, and copper is more preferred, and at least one selected from the group consisting of aluminum, magnesium, and silver is still more preferred.

It suffices that the organic compound in the thin film-modified electrode of the first aspect of the present invention has the sum of distances from the atoms capable of coordinating to metal in the organic compound to an aluminum atom of 4.06 Å or less, as determined from a structure optimized by density functional theory calculations, where the aluminum atom is set as the metal, using functional: B3LYP/basis set: 6-31G**. The sum of distances is preferably 4.055 Å or less, more preferably 4.05 Å or less.

The organic compound may be any one having the sum of distances of 4.06 Å or less, and is preferably an organic compound containing atoms capable of coordinating to metal selected from the group consisting of a nitrogen atom, a sulfur atom, and an oxygen atom. The organic compound is more preferably a multidentate organic compound having an electron-donating nitrogen atom in a heterocycle, still more preferably an organic compound having a fused heterocyclic structure.

An example of the multidentate organic compound having an electron-donating nitrogen atom in a heterocycle and having a fused heterocyclic structure is a compound having a structure represented by the formula (1) below. In other words, the organic compound in the thin film-modified electrode of the first aspect of the present invention is preferably a compound having a structure represented by the following formula (1) having the sum of distances from the atoms capable of coordinating to metal in the organic compound to an aluminum atom of 4.06 Å or less.

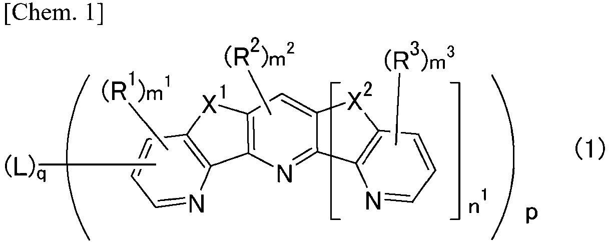

In the formula (1), X¹ and X² are the same as or different from each other and each represent a nitrogen atom optionally having a substituent, an oxygen atom optionally having a substituent, a sulfur atom optionally having a substituent, or a divalent linking group optionally having a substituent; L is a direct bond or a linking group having a valence of p; n¹ is the number of 0 or 1; p is the number of 1 to 4; q is the number of 0 or 1, with q being 0 when p is 1; R¹ to R³ are the same as or different from each other and each represent a monovalent substituent; m¹ to m³ are the same as or different from each other and each represent the number of 0 to 3; R¹ to R³ are each optionally bonded to X¹ or X² to form a ring structure; and when a plurality of R¹s are present, R¹s are optionally bonded to each other to form a ring structure, with the same applying to R² and R³.

X¹ and X² in the formula (1) are the same as or different from each other and each represent a nitrogen atom optionally having a substituent, an oxygen atom optionally having a substituent, a sulfur atom optionally having a substituent, or a divalent linking group optionally having a substituent.

Examples of the divalent linking group include a divalent hydrocarbon group and a group in which at least one of the carbon atoms of a hydrocarbon group is replaced with a heteroatom selected from a nitrogen atom, an oxygen atom, and a sulfur atom.

The hydrocarbon group preferably has 1 to 6 carbon atoms, more preferably 1, 2, or 6 carbon atoms.

The hydrocarbon group may be linear, branched, or cyclic, or may include a combination of two or more of these structures.

The divalent hydrocarbon group may be a saturated hydrocarbon group such as an alkylene group or may be an unsaturated hydrocarbon group such as an alkenylene group or an alkynylene group.

Specifically, the divalent hydrocarbon group is preferably any of compounds represented by the formulas (2-1) to (2-4) below. Rs in the formulas (2-1) to (2-4) are substituents. Specific examples of the substituents for Rs in the formulas (2-1) to (2-4) as well as the substituents in X¹ and X² include monovalent substituents for R¹ to R³ described later.

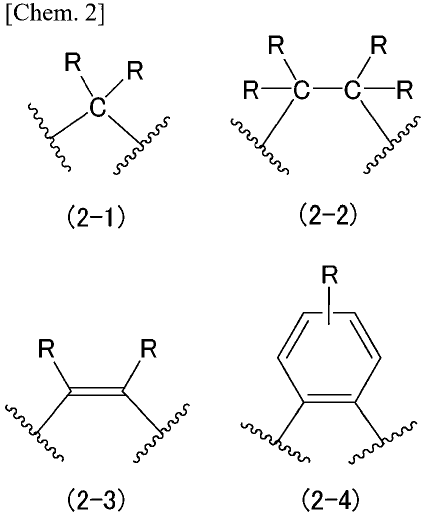

L in the formula (1) is a direct bond or a linking group having a valence of p. L is a direct bond only when p is 2.

Examples of the linking group having a valence of p include nitrogen, oxygen, sulfur, and carbon atoms, and a group obtained by removing p number of hydrogen atoms from a hydrocarbon group or a group in which at least one of the carbon atoms of a hydrocarbon group is replaced with a heteroatom selected from a nitrogen atom, an oxygen atom, and a sulfur atom.

When the linking group having a valence of p contains a carbon atom, the number of carbon atoms is preferably 1 to 30, more preferably 1 to 20.

The hydrocarbon group may be linear, branched, or cyclic, or may include a combination of two or more of these structures.

The hydrocarbon group may be any of a saturated hydrocarbon group, an unsaturated hydrocarbon group, and an aromatic hydrocarbon group.

Examples of the aromatic hydrocarbon group include groups obtained by removing a hydrogen atom from an aromatic compound such as a benzene ring, a naphthalene ring, an anthracene ring, a tetracene ring, a pentacene ring, a triphenylene ring, a pyrene ring, a fluorene ring, or an indene ring.

R¹ to R³ in the formula (1) are the same as or different from each other and each represent a monovalent substituent.

Examples of the monovalent substituent include a fluorine atom; haloalkyl groups such as fluoromethyl, difluoromethyl, and trifluoromethyl groups; C1-C20 linear or branched acyclic alkyl groups such as methyl, ethyl, propyl, isopropyl, butyl, isobutyl, and tert-butyl groups; C5-C7 cyclic alkyl groups such as cyclopentyl, cyclohexyl, and cycloheptyl groups; C1-C20 linear or branched acyclic alkoxy groups such as methoxy, ethoxy, propoxy, isopropoxy, butoxy, isobutoxy, tert-butoxy, pentyloxy, hexyloxy, heptyloxy, and octyloxy groups; a nitro group; a cyano group; C1-C10 alkyl group-containing alkylamino groups such as methylamino, ethylamino, dimethylamino, and diethylamino groups; cyclic amino groups such as pyrrolidino, piperidino, and morpholino groups; diarylamino groups such as diphenylamino and carbazolyl groups; acyl groups such as acetyl, propionyl, and butyryl groups; C2-C30 alkenyl groups such as a styryl group; a C5-C20 aryl group optionally substituted with a halogen atom such as a fluorine atom, a C1-C20 alkyl group, a C1-C20 alkoxy group, a C1-C20 amino group, or the like (specific examples of the aryl group include the above-described examples of the aromatic hydrocarbon group); a C4-C40 heterocyclic group containing at least one of a nitrogen atom, a sulfur atom, or an oxygen atom, optionally substituted with a halogen atom such as a fluorine atom, a C1-C20 alkyl group, a C1-C20 alkoxy group, a C 1-C20 amino group, or the like (the heterocyclic group may consist of one ring or may be a compound in which multiple compounds each consisting of one aromatic heterocycle are directly bonded to each other via a carbon-carbon bond, or a fused heterocyclic group. Specific examples of the heterocyclic group include aromatic heterocyclic groups such as a thiophene ring, a furan ring, a pyrrole ring, a benzothiophene ring, a benzofuran ring, an indole ring, a dibenzothiophene ring, a dibenzofuran ring, a carbazole ring, a thiazole ring, a benzothiazole ring, an oxazole ring, a benzoxazole ring, an imidazole ring, a benzimidazole ring, a pyridine ring, a pyrimidine ring, a pyrazine ring, a pyridazine ring, a triazole ring, a benzotriazole ring, a triazine ring, a quinoline ring, an isoquinoline ring, a quinoxaline ring, a benzothiadiazole ring, and a phenanthridine ring); ester groups and thioether groups; and combinations of these. These groups may be substituted with a halogen atom, a heteroatom, an alkyl group, or an aromatic ring, for example.

The compound represented by the formula (1) may be a compound having a structure represented by the following formula (3) containing one phenanthroline skeleton, and this compound is also suitable as a material for forming the thin film-modified electrode of the first aspect of the present invention.

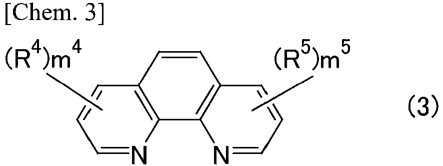

In the formula (3), R⁴ and R⁵ are the same as or different from each other and each represent a dialkylamino group, a nitrogen-containing heterocyclic group, or an alkoxy group; m⁴ and m⁵ are the same as or different from each other and each represent the number of 1 or 2; when a plurality of R⁴s are present, R⁴s are optionally bonded to each other to form a ring structure, with the same applying to R⁵; and the two alkyl groups in each of the dialkylamino groups represented by R⁴ and R⁵ may be bonded to form a ring structure.

R⁴ and R⁵ in the formula (3) are the same as or different from each other and each represent a dialkylamino group, a nitrogen-containing heterocyclic group, or an alkoxy group.

Preferably, the dialkylamino group has a C1-C20 alkyl group such as a methyl group or an ethyl group. More preferably, the dialkylamino group has a C1-C10 alkyl group. The numbers of carbon atoms of the two alkyl groups in the dialkylamino group may be the same as or different from each other. An amino group in which two alkyl groups are bonded such as a cyclic amino group (e.g., a piperidino group, a pyrrolidino group, or a morpholino group) is also preferred. The cyclic amino group is preferably a cyclic amino group having a structure in which one or more acyclic or cyclic alkyl groups are bonded to a nitrogen-containing heterocycle; a cyclic amino group having a structure in which a group formed by bonding one or more aromatic rings to a carbon atom or an acyclic alkyl group is bonded to a nitrogen-containing heterocycle; or a cyclic amino group having a structure in which two alkyl groups bonded to a nitrogen-containing heterocycle are bonded to each other to form a ring, and the nitrogen-containing heterocycle and the hydrocarbon ring are fused together.

Preferred examples of the nitrogen-containing heterocyclic group include a triazolyl group and a benzotriazolyl group.

Examples of the alkoxy group include the alkoxy groups for R¹ to R³ in the formula (1).

Examples of a compound having a structure represented by the formula (1) having the sum of distances from the atoms capable of coordinating to metal in the compound to an aluminum atom of 4.06 Å or less include those represented by the following formulas (4-1) to (4-5).

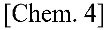

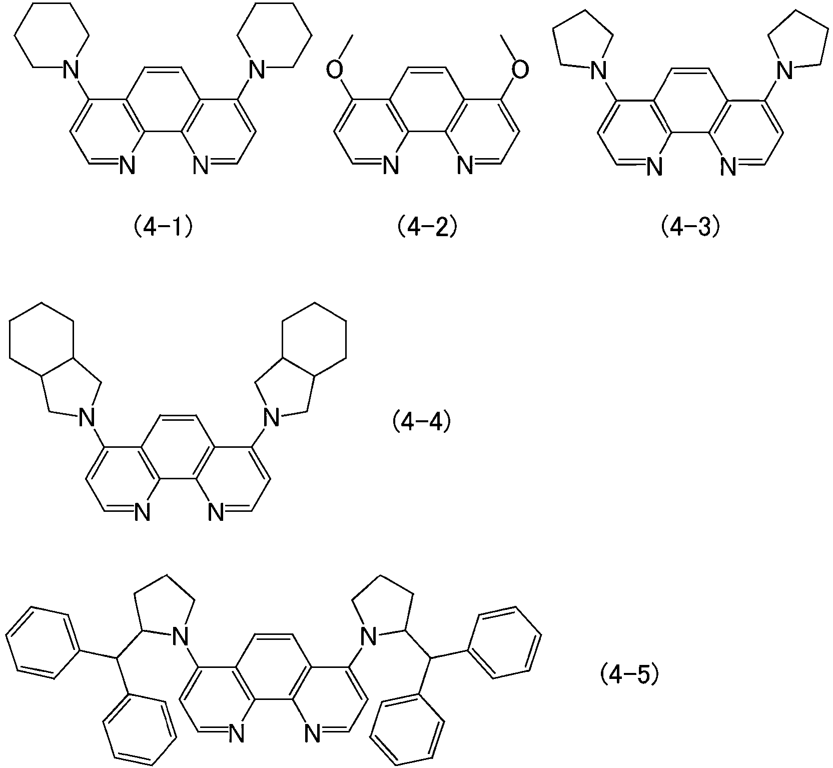

The organic compound in the first aspect of the present invention may be a hexahydropyrimidopyrimidine compound having a structure represented by the following formula (5): 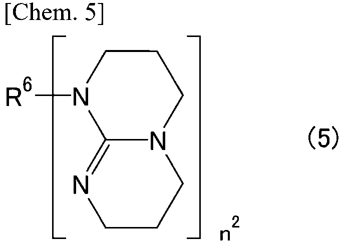 wherein R⁶ is an aromatic hydrocarbon group optionally having a substituent, an aromatic heterocyclic group optionally having a substituent, an arylalkylene group optionally having a substituent, a divalent to tetravalent acyclic or cyclic hydrocarbon group optionally having a substituent, a group of a combination of two or more of these groups, or a group of a combination of a nitrogen atom and one or more of these groups; and n² is an integer of 1 to 4.

The hexahydropyrimidopyrimidine compound having a structure represented by the formula (5) can coordinate to metal species, preventing reactions at the interface with oxygen or water entering from the outside, and enhancing the air stability of the device. Furthermore, a dipole induced by interaction with metal species can improve the electron injection properties of the thin film-modified electrode.

In the formula (5), R⁶ is an aromatic hydrocarbon group optionally having a substituent, an aromatic heterocyclic group optionally having a substituent, an arylalkylene group optionally having a substituent, a divalent to tetravalent acyclic or cyclic hydrocarbon group optionally having a substituent, a group of a combination of two or more of these groups, or a group of a combination of a nitrogen atom and one or more of these groups.

The aromatic hydrocarbon group and the aromatic heterocyclic group each preferably have 3 to 30 carbon atoms, more preferably 4 to 24 carbon atoms, still more preferably 5 to 20 carbon atoms.

Examples of the aromatic hydrocarbon group include a compound consisting of one aromatic ring (e.g., benzene); a compound in which multiple aromatic rings are directly bonded to each other via a carbon-carbon bond (e.g., biphenyl or diphenylbenzene); and a group prepared by removing 1 to 4 hydrogen atoms from any of the aromatic rings of a fused cyclic aromatic hydrocarbon compound such as naphthalene, anthracene, phenanthrene, or pyrene.

Examples of the aromatic heterocyclic group include a compound consisting of one aromatic heterocycle (e.g., thiophene, furan, pyrrole, oxazole, oxadiazole, thiazole, thiadiazole, imidazole, pyridine, pyrimidine, pyrazine, or triazine); a compound in which any two or more of the compounds each consisting of one aromatic heterocycle are directly bonded to each other via a carbon-carbon bond (e.g., bipyridine); and a group prepared by removing 1 to 4 hydrogen atoms from any of the aromatic heterocycles of a fused cyclic heteroaromatic hydrocarbon compound such as quinoline, quinoxaline, benzothiophene, benzothiazole, benzimidazole, benzoxazole, indole, carbazole, dibenzofuran, dibenzothiophene, acridine, or phenanthroline.

The arylalkylene group may be a group of a combination of any of the aromatic hydrocarbon groups and a C1-C3 alkylene group.

The divalent to tetravalent acyclic or cyclic hydrocarbon group preferably has 1 to 12 carbon atoms, more preferably 1 to 6 carbon atoms, still more preferably 1 to 4 carbon atoms. The acyclic hydrocarbon group may be linear or branched.

R⁶ may be a group of a combination of two or more selected from the aromatic hydrocarbon groups, the aromatic heterocyclic groups, the arylalkylene groups, and the divalent to tetravalent acyclic hydrocarbon groups.

R⁶ may also be a group of a combination of a nitrogen atom and one or more groups selected from the aromatic hydrocarbon groups, the aromatic heterocyclic groups, the arylalkylene groups, and the divalent to tetravalent acyclic hydrocarbon groups. Examples of the group include groups prepared by removing 1 to 4 hydrogen atoms from triphenylamine or a trialkylamine such as trimethylamine.

The aromatic hydrocarbon group, the aromatic heterocyclic group, and the arylalkylene group may each contain one or more monovalent substituents.

Examples of the monovalent substituents include those mentioned as the specific examples of the monovalent substituent for R¹ to R³ in the formula (1).

In the formula (5), n² is an integer of 1 to 4, preferably 2 or 3.

The organic compound in the first aspect of the present invention may be a triazine compound having a structure represented by the following formula (6): 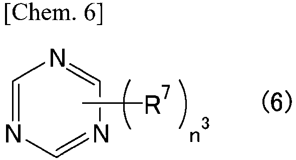 wherein R⁷s are the same as or different from each other and each represent an aromatic hydrocarbon group optionally having a substituent, an aromatic heterocyclic group optionally having a substituent, an arylalkylene group optionally having a substituent, a divalent to tetravalent acyclic or cyclic hydrocarbon group optionally having a substituent, a group of a combination of two or more of these groups, or a group of a combination of a nitrogen atom and one or more of these groups; and n³ is an integer of 0 to 3.

The triazine compound having a structure represented by the formula (6) has electron transport properties and can exhibit both electron injection properties and electron transport properties.

Specific examples of R⁷ in the formula (6) are the same as those of R⁶ in the formula (5). Of these, groups formed by combining an aromatic hydrocarbon group with an aromatic heterocyclic group are preferred, and a phenyl group to which an aromatic heterocycle such as a pyridine ring is bonded is preferred, for example.

The n³ is an integer from 0 to 3, preferably 3.

The electrode in the thin film-modified electrode of the first aspect of the present invention serves as a cathode.

The cathode is preferably made of a material having a work function of 4.0 eV or higher, and examples include conductive oxide materials such as indium tin oxide (ITO), indium zinc oxide (IZO), fluorine tin oxide (FTO), In₃O₃, SnO₂, Sb-containing SnO₂, and Al-containing ZnO, and silver and silver alloys. Of these materials for the cathode, ITO, IZO, FTO, and silver are preferred.

The cathode may have any average thickness, and the average thickness is preferably 10 to 500 nm, more preferably 100 to 200 nm. When the cathode is made of silver, the average thickness of the cathode is preferably 5 to 40 nm, more preferably 10 to 20 nm.

The average thickness of the cathode can be measured using a stylus profiler or spectroscopic ellipsometry.

### 2-1. Method of producing thin film-modified electrode of the first aspect of the present invention and method of selecting material for electron injection layer of organic device

As described above, a thin film-modified electrode excellent in electron injection properties and air stability can be produced by forming a layer on an electrode using a metal and an organic compound suitable for electrode modification selected using density functional theory calculations. The present invention also encompasses such a method of producing a thin film-modified electrode, specifically, a method of producing a thin film-modified electrode, the method including: a first step of selecting an organic compound capable of coordinating to a metal, the organic compound containing atoms capable of coordinating to metal and having a sum of distances from the atoms capable of coordinating to metal in the organic compound to an aluminum atom of 4.06 Å or less, as determined from a structure optimized for the organic compound by density functional theory calculations, where the aluminum atom is set as the metal, using functional: B3LYP/basis set: 6-31G**; and a second step including forming, using the organic compound selected in the first step and a metal, a layer containing the organic compound and the metal, the layer being in contact with an electrode, or forming sequentially a layer containing the metal, the layer being in contact with an electrode, and a layer containing the organic compound, the layer being in contact with the layer containing the metal.

The present invention also encompasses a method of selecting a material for an electron injection layer of an organic device as in the method of producing the thin film-modified electrode of the present invention.

In the second step in the method of producing the thin film-modified electrode of the first aspect of the present invention, forming a layer containing the organic compound and the metal, the layer being in contact with an electrode, or forming sequentially a layer containing the metal, the layer being in contact with an electrode, and a layer containing the organic compound, the layer being in contact with the layer containing the metal, may be performed by the same method as the method of forming an inorganic compound layer or an organic compound layer of an organic device described later.

### <Thin film-modified electrode of the second aspect of the present invention>

The thin film-modified electrode of the second aspect of the present invention, when containing an organic compound capable of coordinating to a metal and having a high equilibrium density, can suppress the diffusion of water molecules and can exhibit improved air stability.

As described above for the thin film-modified electrode of the first aspect of the present invention, when an organic device is used in air, the emitting surface degrades over time. The relationship between the degraded area width of the emitting surface and the elapsed time can be approximated using a diffusion equation, and from which the degradation (shrinkage) growth rate is determined. Thereby, the air stability of the organic device can be evaluated.

As shown in the EXAMPLES described later, the shrinkage growth rates of organic devices produced using a plurality of organic compounds with different structures as compounds each capable of coordinating to a metal have a correlation with the equilibrium density of intermolecular packing determined by molecular dynamics calculations from a structure optimized for the corresponding organic compound by density functional theory calculations using functional: B3LYP-D3/basis set: 6-31G**. This is considered to be because when the density of the organic compound is high, moisture and air hardly diffuse in the organic device. Use of an organic compound having an equilibrium density of 1.17 g/cm³ or more, as determined by molecular dynamics calculations, in combination with a metal to which the organic compound can coordinate can provide an organic device excellent in electron injection properties and air stability.

The "equilibrium density determined by molecular dynamics calculations" is the density obtained by equilibrium calculations, based on molecular dynamics, of the intermolecular distance in a system where identical molecules are adjacently packed in an amorphous state.

### 1-2. Thin film-modified electrode of the second aspect of the present invention

The thin film-modified electrode of the second aspect of the present invention may include an electrode, and (i) a layer containing a metal and an organic compound capable of coordinating to the metal and having a calculated equilibrium density of 1.17 g/cm³ or more, the layer being in contact with (in direct contact with) the electrode, or (ii) both a layer containing a metal, the layer being in contact with (in direct contact with) the electrode, and a layer containing an organic compound capable of coordinating to the metal and having an equilibrium density of 1.17 g/cm³ or more, the layer being in contact with the layer containing a metal. The thin film-modified electrode of the second aspect of the present invention preferably includes (ii) two layers consisting of a layer containing a metal, the layer being in contact with the electrode, and a layer containing the organic compound, the layer being in contact with the layer containing a metal (in other words, an electrode, a layer containing a metal, and a layer containing an organic compound capable of coordinating to the metal and having an equilibrium density of 1.17 g/cm³ or more are sequentially formed, each being in contact with the next). In such a structure, the coordination reaction between the metal and the organic compound can be utilized more efficiently to improve the electron injection properties. In addition, the formation of a dense film can slow down the diffusion of water molecules.

When the thin film-modified electrode of the second aspect of the present invention includes (ii) both a layer containing a metal, the layer being in contact with the electrode, and a layer containing an organic compound capable of coordinating to the metal and having an equilibrium density of 1.17 g/cm³ or more, the layer being in contact with the layer containing a metal, the layer containing a metal may be a metal layer of a single metal element, a multilayer including two or more layers selected from the group consisting of a layer of a mixture of two or more metal elements and a layer of a single metal element, or a layer of a mixture of two or more metal elements.

When the thin film-modified electrode of the present invention includes (ii) both a layer containing a metal, the layer being in contact with the electrode, and a layer containing an organic compound capable of coordinating to the metal and having an equilibrium density of 1.17 g/cm³ or more, the layer being in contact with the layer containing a metal, the layer containing an organic compound may further contain an electron transport material described later.

When the thin film-modified electrode of the second aspect of the present invention includes (i) a single layer containing a metal and an organic compound capable of coordinating to the metal and having an equilibrium density of 1.17 g/cm³ or more, the layer being in contact with the electrode, the single layer containing a metal and an organic compound preferably has a thickness of 0.1 to 50 nm, more preferably 0.1 to 10 nm.

When the thin film-modified electrode of the second aspect of the present invention includes (ii) both a layer containing a metal, the layer being in contact with the electrode, and a layer containing an organic compound capable of coordinating to the metal and having an equilibrium density of 1.17 g/cm³ or more, the layer being in contact with the layer containing a metal, the layer containing a metal preferably has a thickness of 0.1 to 5 nm, more preferably 0.5 to 2 nm. The layer containing an organic compound capable of coordinating to the metal and having an equilibrium density of 1.17 g/cm³ or more preferably has a thickness of 0.5 to 10 nm, more preferably 1 to 5 nm, still more preferably 1 to 3 nm.

The thickness of each layer can be measured using a stylus profiler, spectroscopic ellipsometry, or X-ray photoelectron spectroscopy.

The metal in the layer that is in contact with the electrode in the thin film-modified electrode of the second aspect of the present invention may be any metal to which an organic compound can coordinate.

Specific examples and preferred examples of the metal in the layer that is in contact with the electrode are the same as those for the thin film-modified electrode of the first aspect of the present invention described above.

It suffices that the organic compound in the thin film-modified electrode of the second aspect of the present invention has an equilibrium density of intermolecular packing of 1.17 g/cm³ or more, as determined by molecular dynamics calculations from a structure optimized by density functional theory calculations using functional: B3LYP-D3/basis set: 6-31G**. The equilibrium density is preferably 1.20 g/cm³ or more, more preferably 1.25 g/cm³ or more.

The organic compound may be any one having an equilibrium density of 1.17 g/cm³ or more, and is preferably an organic compound containing atoms capable of coordinating to metal selected from the group consisting of a nitrogen atom, a sulfur atom, and an oxygen atom. The organic compound is more preferably a multidentate organic compound having an electron-donating nitrogen atom in a heterocycle, still more preferably an organic compound having a fused heterocyclic structure.

An example of the multidentate organic compound having an electron-donating nitrogen atom in a heterocycle and having a fused heterocyclic structure is a compound having a structure represented by the formula (1).

In other words, the organic compound in the thin film-modified electrode of the second aspect of the present invention is preferably a compound having a structure represented by the formula (1) and having an equilibrium density of 1.17 g/cm³ or more.

The compound represented by the formula (1) may be a compound having a structure represented by the formula (3) containing one phenanthroline skeleton, and this compound is also suitable as a material for forming the thin film-modified electrode of the second aspect of the present invention.

Examples of the compound having a structure represented by the formula (1) and having an equilibrium density of 1.17 g/cm³ or more include compounds represented by the following formulas (7-1) to (7-3):

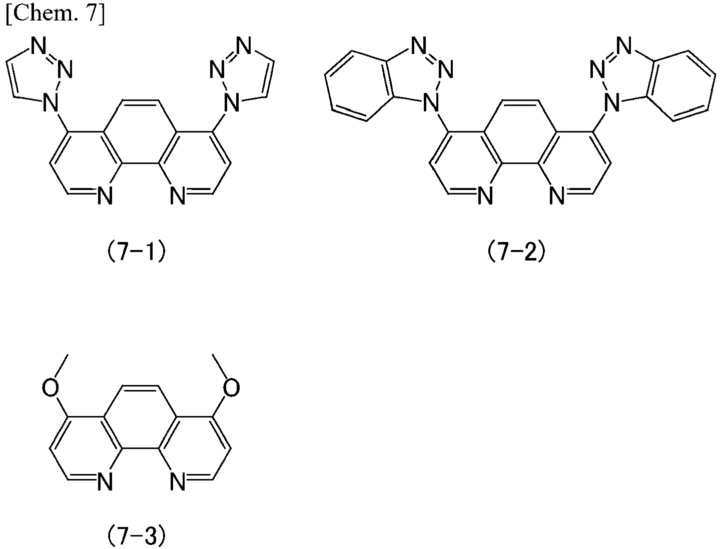

The organic compound in the second aspect of the present invention may be a hexahydropyrimidopyrimidine compound having a structure represented by the formula (5). In this case, specific examples and preferred structures of the hexahydropyrimidopyrimidine compound having a structure represented by the formula (5) are the same as those described above.

The organic compound in the second aspect of the present invention may be a triazine compound having a structure represented by the formula (6). In this case, specific examples and preferred structures of the triazine compound having a structure represented by the formula (6) are the same as those described above.

The electrode in the thin film-modified electrode of the second aspect of the present invention serves as a cathode.

The material of the cathode is the same as that of the electrode (cathode) in the thin film-modified electrode of the first aspect of the present invention.

The average thickness of the thin film-modified electrode (cathode) of the second aspect of the present invention is also the same as that of the thin film-modified electrode (cathode) of the first aspect of the present invention.

### 2-2. Method of producing thin film-modified electrode of the second aspect of the present invention and method of selecting material for electron injection layer of organic device

As described above, a thin film-modified electrode excellent in electron injection properties and air stability can be produced by forming a layer on an electrode using a metal and an organic compound suitable for electrode modification selected using molecular dynamics calculations. The present invention also encompasses such a method of producing a thin film-modified electrode, specifically, a method of producing a thin film-modified electrode, the method including: a first step of selecting an organic compound capable of coordinating to a metal, the organic compound having an equilibrium density of intermolecular packing of 1.17 g/cm³ or more, as determined by molecular dynamics calculations from a structure optimized for the organic compound by density functional theory calculations using functional: B3LYP-D3/basis set: 6-31G**; and a second step including forming, using the organic compound selected in the first step and a metal, a layer containing the organic compound and the metal, the layer being in contact with an electrode, or forming sequentially a layer containing the metal, the layer being in contact with an electrode, and a layer containing the organic compound, the layer being in contact with the layer containing the metal.

The present invention also encompasses a method of selecting a material for an electron injection layer of an organic device as in the method of producing the thin film-modified electrode of the second aspect of the present invention, specifically, a method of selecting an organic compound suitable as a material used in combination with a metal to form an electron injection layer of an organic device, the method including selecting, as the material used in combination with a metal to form an electron injection layer of an organic device, an organic compound capable of coordinating to the metal, the organic compound having an equilibrium density of intermolecular packing of 1.17 g/cm³ or more, as determined by molecular dynamics calculations from a structure optimized for the organic compound by density functional theory calculations using functional: B3LYP-D3/basis set: 6-31G**.

In the second step in the method of producing the thin film-modified electrode of the second aspect of the present invention, forming a layer containing the organic compound and the metal, the layer being in contact with an electrode, or forming sequentially a layer containing the metal, the layer being in contact with an electrode, and a layer containing the organic compound, the layer being in contact with the layer containing the metal, may be performed by the same method as the method of forming an inorganic compound layer or an organic compound layer of an organic device described later.

### 3. Organic device and method of producing the same

The organic device of the present invention may have any configuration including the thin film-modified electrode of the first aspect of the present invention or the thin film-modified electrode of the second aspect of the present invention. Preferably, the organic device sequentially includes a thin film-modified electrode, an electron transport layer, an emitting layer, at least one of a hole transport layer or a hole injection layer, and an anode, each being in contact with the next. Each of these layers may consist of a single layer or two or more layers. The organic device may be free of an electron transport layer, when the organic device includes the thin film-modified electrode of the first aspect of the present invention in which the layer containing an organic compound capable of coordinating to a metal and having the sum of distances of 4.06 Å or less further contains an electron transport material, or when the organic device includes the thin film-modified electrode of the second aspect of the present invention in which the layer containing an organic compound capable of coordinating to a metal and having an equilibrium density of 1.17 g/cm³ or more further contains an electron transport material. In this case, the organic device sequentially includes a thin film-modified electrode, an emitting layer, at least one of a hole transport layer or a hole injection layer, and an anode, each being in contact with the next.

In the organic device having the structure described above, when the device includes either a hole transport layer or a hole injection layer, the layer is stacked in contact with the emitting layer and the anode. When the device includes both a hole transport layer and a hole injection layer, the emitting layer, the hole transport layer, the hole injection layer, and the anode are sequentially stacked, each being in contact with the next.

The organic device of the present invention may be an organic device of a normal structure in which an anode is formed in contact with a substrate, or an organic device of an inverted structure in which the thin film-modified electrode of the present invention is formed in contact with a substrate. Preferably, the organic device of the present invention is an organic device of an inverted structure because the device can exhibit higher air stability.

The material for the electron transport layer may be any of compounds commonly used as an electron transport layer material, or may be a mixture of these.

Specific examples of the material for the electron transport layer include phosphine oxide derivatives such as phenyl-dipyrenylphosphine oxide (POPy₂); pyridine derivatives such as tris-1,3,5-(3'-(pyridin-3-yl)phenyl) benzene (TmPhPyB); quinoline derivatives such as (2-(3-(9-carbazolyl)phenyl)quinoline (mCQ)); pyrimidine derivatives such as 2-phenyl-4,6-bis(3,5-dipyridylphenyl) pyrimidine (BPyPPM); pyrazine derivatives; phenanthroline derivatives such as bathophenanthroline (BPhen); triazine derivatives such as 2,4-bis(4-biphenyl)-6-(4'-(2-pyridinyl)-4-biphenyl)-[1,3,5]triazine (MPT); triazole derivatives such as 3-phenyl-4-(1'-naphthyl)-5-phenyl-1,2,4-triazole (TAZ); oxazole derivatives; oxadiazole derivatives such as 2-(4-biphenyl)-5-(4-tert-butylphenyl-1,3,4-oxadiazole) (PBD); imidazole derivatives such as 2,2',2"-(1,3,5-benzenetriyl)-tris(1-phenyl-1-H-benzimidazole) (TPBI); aromatic carboxylic anhydrides such as naphthalene-1,4,5,8-tetracarboxylic dianhydride and 3,4,9,10-perylene tetracarboxylic dianhydride; aromatic imide compounds such as N,N'-dimethyl-3,4,9,10-perylene tetracarboxylic imide; carbonyl-containing compounds such as an isoindigo derivative, a 2,5-dihydropyrrolo[3,4-c]pyrrole-1,4-dione derivative (diketopyrrolopyrrole), and truxenone; 1,2,5-thiadiazole derivatives such as naphtho[1,2-c:5,6-c']bis[1,2,5] thiadiazole and benzo[c][1,2,5]thiadiazole; various metal complexes typified by bis[2-(2-hydroxyphenyl)benzothiazolato]zinc (Zn(BTZ)₂) and tris(8-hydroxyquinolinato)aluminum (Alq₃); organic silane derivatives typified by silole derivatives such as 2,5-bis(6'-(2',2"-bipyridyl))-1,1-dimethyl-3,4-diphenylsilole (PyPySPyPy); anthracene derivatives such as 9-(1-naphthyl)-10-(2-naphthyl)anthracene (1,2-ADN); and boron-containing compounds such as tris(2,4,6-trimethyl-3-(pyridin-3-yl)phenyl)borane (3TPYMB) and compounds disclosed in Japanese Patent Application No. 2012-228460, Japanese Patent Application No. 2015-503053, Japanese Patent Application No. 2015-053872, Japanese Patent Application No. 2015-081108, and Japanese Patent Application No. 2015-081109. One or more of these may be used.

Examples of the material for the electron transport layer include, in addition to these materials, aromatic hydrocarbon compounds which are a variety of hydrocarbon compounds each containing an aromatic ring, compounds having a nitrogen-boron bond, π-electron-rich heteroaromatic compounds containing an aromatic ring such as a pyrrole ring, a furan ring, or a thiophene ring, and compounds containing a silole ring.

Of these, phosphine oxide derivatives such as POPy₂, metal complexes such as Alq₃, pyridine derivatives such as TmPhPyB, and anthracene derivatives are particularly preferred.

As described above, the organic device may be free of an electron transport layer, when the organic device of the present invention includes the thin film-modified electrode of the first aspect of the present invention formed using a layer containing a metal and a mixture of the electron transport material described above and an organic compound capable of coordinating to the metal and having the sum of distances of 4.06 Å or less, or when the organic device of the present invention includes the thin film-modified electrode of the second aspect of the present invention formed using a layer containing a metal and a mixture of the electron transport material described above and an organic compound capable of coordinating to the metal and having an equilibrium density of 1.17 g/cm³ or more. Also, a hole blocking layer may be formed using part of the electron transport material as a hole blocking layer material. In addition, any commonly used hole blocking layer material may be used, as needed.

When the organic device of the present invention includes an electron transport layer, the average thickness of the electron transport layer is preferably, but not limited to, 10 to 150 nm, more preferably 20 to 100 nm.

The average thickness of the electron transport layer can be measured using a stylus profiler or spectroscopic ellipsometry.

The material for forming the emitting layer of the organic device of the present invention may be any of compounds commonly used as an emitting layer material. The material may be a low-molecular compound, a high-molecular compound, or a mixture of these.

The low-molecular material in the present invention refers to a material that is not a high-molecular material (polymer), and does not necessarily refer to an organic compound having a low molecular weight.

For example, the emitting layer may contain bis[2-[(2-benzothiazolyl)phenolato]zinc (II) (Zn(BTZ)₂) and tris[1-phenylisoquinoline]iridium(III) (Ir(piq)₃) as materials.

Examples include various metal complexes such as a three-coordinate iridium complex having 2,2'-bipyridine-4,4'-dicarboxylic acid as a ligand, fac-tris(2-phenylpyridine)iridium (Ir(ppy)₃), 8-hydroxyquinoline aluminum (Alq₃), tris(4-methyl-8-quinolinolate) aluminum(III) (Almq₃), 8-hydroxyquinoline zinc (Znq₂), (1,10-phenanthroline)-tris-(4,4,4-trifluoro-1-(2-thienyl)-butane-1,3-dionate) europium(III) (Eu(TTA)₃(phen)), and 2,3,7,8,12,13,17,18-octaethyl-21H,23H-porphin platinum(II); benzene compounds such as distyrylbenzene (DSB) and diaminodistyrylbenzene (DADSB); naphthalene compounds such as naphthalene and Nile Red; phenanthrene compounds such as phenanthrene; chrysene compounds such as chrysene and 6-nitrochrysene; perylene compounds such as perylene and N,N'-bis(2,5-di-t-butylphenyl)-3,4,9,10-perylene-dicarboxyimide (BPPC); coronene compounds such as coronene; anthracene compounds such as anthracene and bisstyrylanthracene; pyrene compounds such as pyrene; pyran compounds such as 4-(dicyanomethylene)-2-methyl-6-(para-dimethylaminostyryl)-4H-pyran (DCM); acridine compounds such as acridine; stilbene compounds such as stilbene; thiophene compounds such as 2,5-dibenzooxazolethiophene; benzooxazole compounds such as benzooxazole; benzimidazole compounds such as benzimidazole; benzothiazole compounds such as 2,2'-(para-phenylenedivinylene)-bisbenzothiazole; butadiene compounds such as bistyryl(1,4-diphenyl-1,3-butadiene) and tetraphenylbutadiene; naphthalimide compounds such as naphthalimide; coumarin compounds such as coumarin; perinone compounds such as perinone; oxadiazole compounds such as oxadiazole; aldazine compounds; cyclopentadiene compounds such as 1,2,3,4,5-pentaphenyl-1,3-cyclopentadiene (PPCP); quinacridone compounds such as quinacridone and quinacridone red; pyridine compounds such as pyrrolopyridine and thiadiazolopyridine; spiro compounds such as 2,2',7,7'-tetraphenyl-9,9'-spirobifluorene; metallic or non-metallic phthalocyanine compounds such as phthalocyanine (H₂Pc) and copper phthalocyanine; and boron compound materials disclosed in JP 2009-155325 A, JP 2011-184430 A, and Japanese Patent Application No. 2011-6458.

The emitting layer may be composed of a host material and a guest material (e.g., a dopant), or may contain an exciplex, as a host, including two organic compounds. The percentage of the guest material (e.g., a dopant) relative to the host material (e.g., an exciplex) is preferably 20% by mass or less, more preferably 10% by mass or less.

The average thickness of the emitting layer is preferably, but not limited to, 10 to 150 nm, more preferably 20 to 100 nm.

The average thickness of the emitting layer can be measured using a quartz crystal thickness monitor in the case of a low-molecular compound or a stylus profiler in the case of a high-molecular compound.

When the organic device of the present invention includes a hole transport layer, the hole transport layer may be made of any of materials commonly used as a hole transport layer material, or a mixture of these. Specifically, materials containing a molecular structure with high donor properties such as a triarylamine, carbazole, phenoxazine, phenazine, acridine, azadibenzopyrene, or julolidine skeleton are preferred. More specifically, m-MTDATA, TPT-1, TAPC, TPDI, HN-D1, HN-D2, N-TPA, EH44, PHZ-2Naph, TBDI, HT-01, N-DPA, spiro-MeO-TAD, Tris-PCz, α-NPD, TcTa, 2-SF-DMAC, 2-SF-PHX, SF-BCz, and FATPA, which are described below, are preferred, for example. Examples of the material for the hole transport layer include N4,N4'-bis(dibenzo[b,d]thiophen-4-yl)-N4,N4'-diphenylbiphenyl-4,4'-diamine (DBTPB), polyarylamine, fluorene-arylamine copolymers, fluorene-bithiophene copolymers, poly(N-vinylcarbazole), polyvinylpyrene, polyvinylanthracene, polythiophene, polyalkylthiophenes, polyhexylthiophene, poly(p-phenylenevinylene), polythienylenevinylene, pyreneformaldehyde resin, ethylcarbazole formaldehyde resin, and derivatives of these.

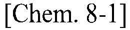

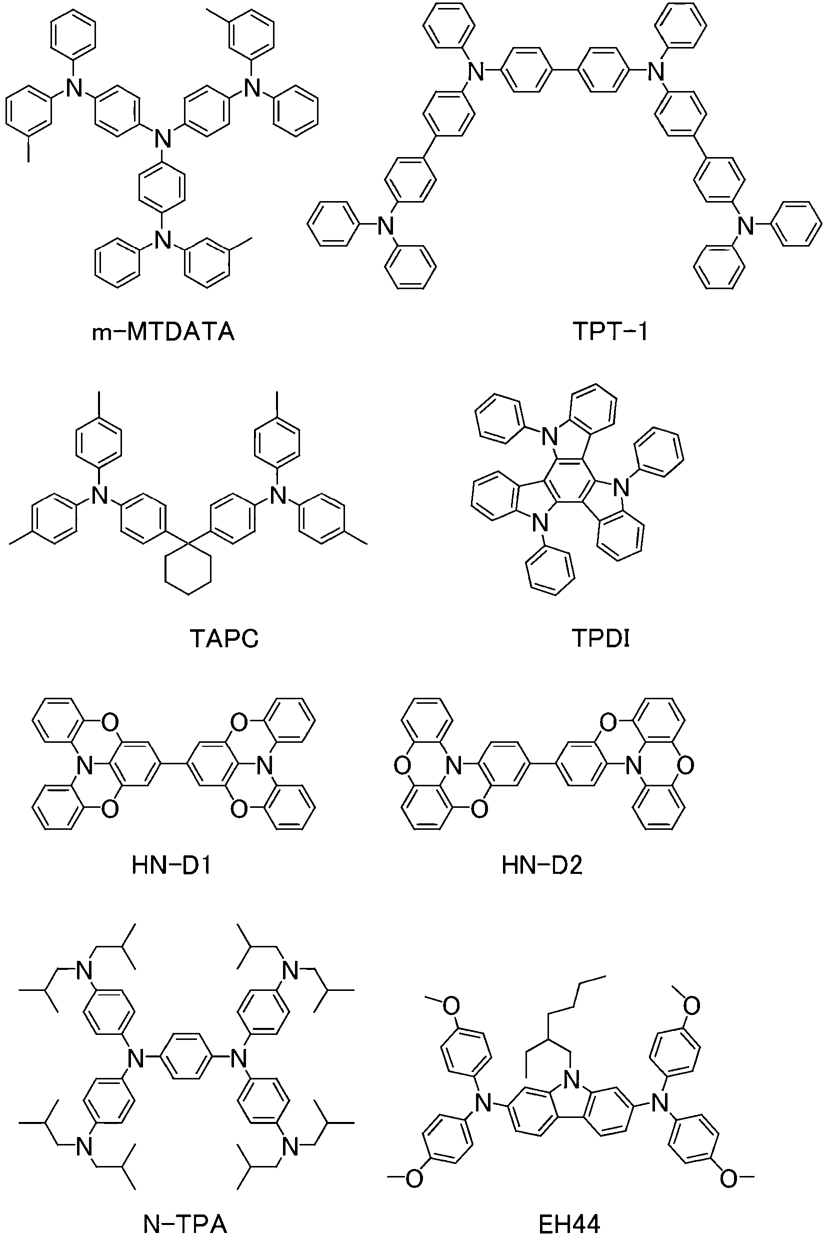

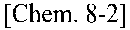

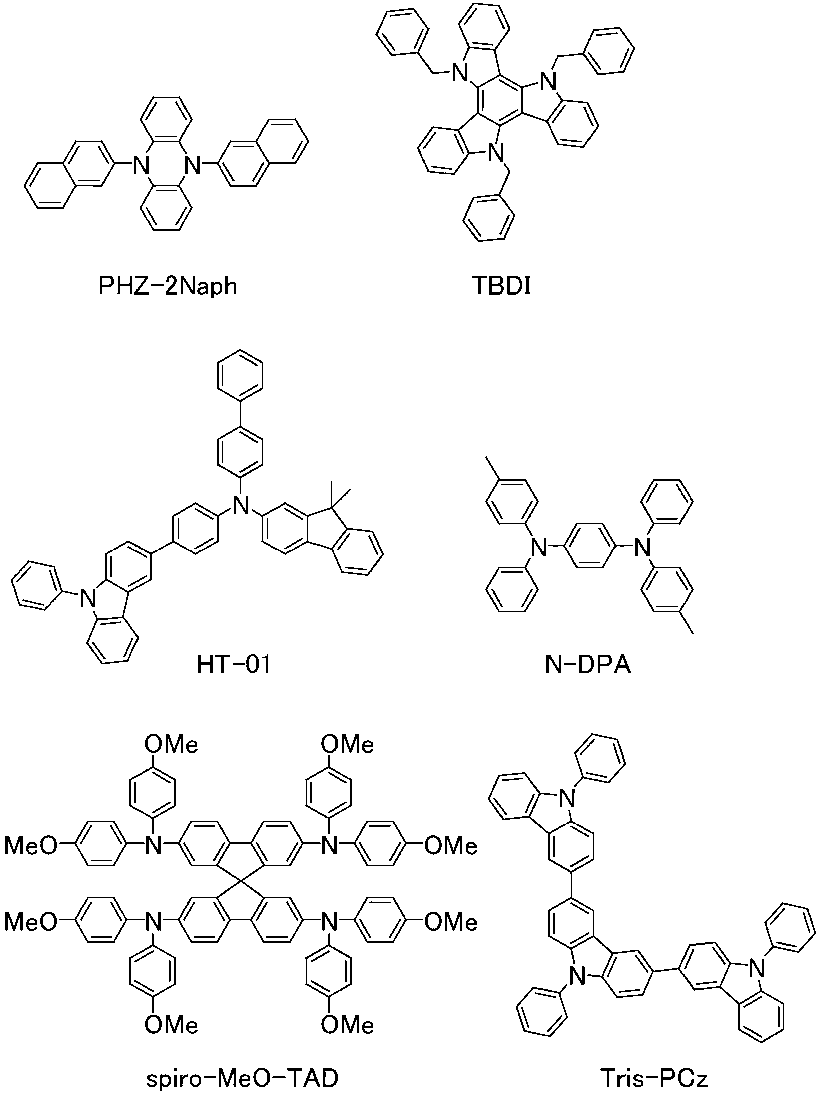

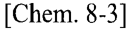

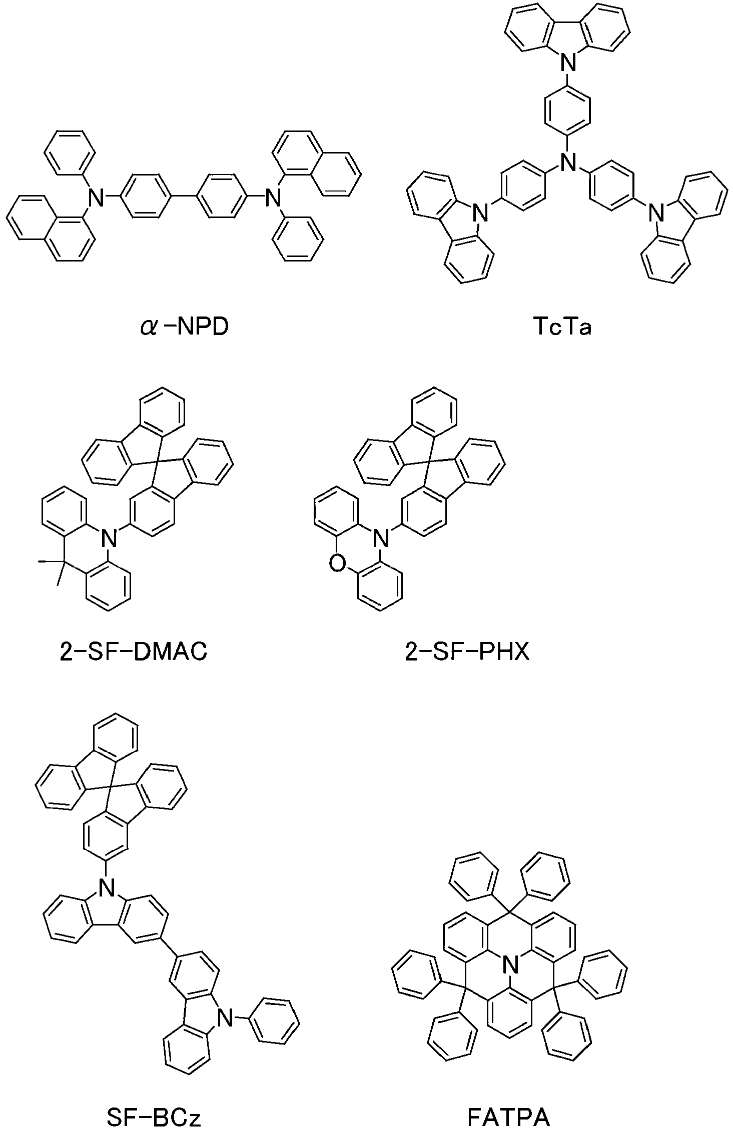

These materials for the hole transport layer can also be used in combination with a different compound as a mixture. An example of a mixture containing polythiophene as a material for the hole transport layer is poly(3,4-ethylenedioxythiophene)/poly(styrene sulfonate) (PEDOT/PSS).

When the organic device of the present invention includes a hole transport layer, the average thickness of the hole transport layer is preferably, but not limited to, 10 to 150 nm, more preferably 20 to 100 nm.

The average thickness of the hole transport layer can be measured using a stylus profiler or spectroscopic ellipsometry.

When the organic device of the present invention includes a hole injection layer, the hole injection layer may be made of an inorganic material or an organic material. Since an inorganic material is more stable than an organic material, the use of an inorganic material easily imparts higher resistance to oxygen and water than the use of an organic material.

Non-limiting examples of the inorganic material include metal oxides such as vanadium oxide (V₂O₅), molybdenum oxide (MoO₃), and ruthenium oxide (RuO₂). One or two or more of these may be used.

Examples of the organic material that can be used include low-molecular materials such as dipyrazino[2,3-f:2',3'-h]quinoxaline-2,3,6,7,10,11-hexacarbonitrile (HAT-CN), 2,3,5,6-tetrafluoro-7,7,8,8-tetracyanoquinodimethane (F4-TCNQ), and 2,2'-(perfluoronaphthalene-2,6-diylidene)dimalononitrile (F6-TCCNNQ), and poly(3,4-ethylenedioxythiophene)/polystyrene sulfonate (PEDOT:PSS).

The average thickness of the hole injection layer is preferably, but not limited to, 1 to 1000 nm, more preferably 5 to 50 nm.

The average thickness of the hole injection layer can be measured using a quartz crystal thickness monitor, a stylus profiler, or spectroscopic ellipsometry during film formation.

Examples of a material for the anode in the organic device of the present invention include ITO, IZO, Au, Pt, Ag, Cu, Al, and alloys containing any of these. Of these, ITO, IZO, Au, Ag, or Al is preferably used.

The average thickness of the anode is preferably, but not limited to, 10 to 1000 nm, more preferably 30 to 150 nm. Even an opaque material can be used as an anode in a top emission device or a transparent type device when it is used with an average thickness of about 10 to 30 nm, for example.

The average thickness of the anode can be measured using a quartz crystal thickness monitor during film formation.

To further improve the properties of the organic device of the present invention, the organic device may include, for example, a layer such as a hole-blocking layer or an electron-blocking layer. These layers may be made of any material commonly used to form these layers and may be formed by any method commonly used to form these layers.

After an electrode is formed as the final layer of the multilayer structure, a passivation layer may be formed thereon to protect the surface. The passivation layer may be made of any material commonly used to form the layer. For example, the material may be at least one material selected from the above-described materials for the hole transport layer and materials for a metal oxide layer, but any other combination of materials may be used.

The average thickness of the passivation layer is preferably, but not limited to, 20 to 300 nm, more preferably 50 to 200 nm.

The average thickness of the passivation layer can be measured using a quartz crystal thickness monitor during film formation.

The substrate of the organic device of the present invention may be, for example, one in which a barrier layer is formed on a base material for sealing.

Examples of a material for the base material include resin materials such as polyethylene terephthalate, polyethylene naphthalate, polypropylene, cycloolefin polymers, polyamide, polyethersulfone, polymethyl methacrylate, polycarbonate, and polyarylate.

Examples of a material for forming the barrier layer on the base material include epoxy resin, acrylic resin, and parylene.

The average thickness of the substrate is preferably 10 to 150 µm, more preferably 10 to 50 µm.

The average thickness of the substrate can be measured using a digital caliper.

The organic device may further include a sealing layer on the passivation layer. The sealing layer may be made of the same material as the substrate, and the thickness of the sealing layer is preferably the same as the thickness of the substrate.

The organic compound layers and inorganic compound coating layers in the organic device of the present invention may be formed by any method, and various methods can be used as appropriate depending on the properties of the materials. In the case of a material that can be applied in the form of a solution, various application methods can be used, such as spin coating, casting, micro gravure coating, gravure coating, bar coating, roll coating, wire bar coating, slit coating, dip coating, spray coating, screen printing, flexographic printing, offset printing, and inkjet printing. To more easily control the film thickness, spin coating and slit coating are preferred of these. In the case of a material that cannot be applied or has low solvent solubility, vacuum deposition and evaporative spray deposition from ultra-dilute solution (ESDUS) are suitable, for example.

When the organic compound layers or the inorganic compound coating layers are formed by applying a solution or dispersion of the corresponding material, various solvents can be used to prepare the solution or the dispersion. Examples of the solvents include: inorganic solvents such as nitric acid, sulfuric acid, ammonia, hydrogen peroxide, water, carbon disulfide, carbon tetrachloride, and ethylene carbonate; organic solvents such as ketone solvents (e.g., methyl ethyl ketone (MEK), acetone, diethyl ketone, methyl isobutyl ketone (MIBK), methyl isopropyl ketone (MIPK), and cyclohexanone), alcohol solvents (e.g., methanol, ethanol, isopropanol, ethylene glycol, diethylene glycol (DEG), and glycerol), ether solvents (e.g., diethyl ether, diisopropyl ether, 1,2-dimethoxyethane (DME), 1,4-dioxane, tetrahydrofuran (THF), tetrahydropyran (THP), anisole, diethylene glycol dimethyl ether (diglyme), and diethylene glycol ethyl ether (carbitol)), cellosolve solvents (e.g., methyl cellosolve, ethyl cellosolve, and phenyl cellosolve), aliphatic hydrocarbon solvents (e.g., hexane, pentane, heptane, and cyclohexane), aromatic hydrocarbon solvents (e.g., toluene, xylene, and benzene), aromatic heterocyclic compound solvents (e.g., pyridine, pyrazine, furan, pyrrole, thiophene, and methylpyrrolidone), amide solvents (e.g., N,N-dimethylformamide (DMF) and N,N-dimethylacetamide (DMA)), halogenated compound solvents (e.g., chlorobenzene, dichloromethane, chloroform, and 1,2-dichloroethane), ester solvents (e.g., ethyl acetate, methyl acetate, and ethyl formate), sulfur compound solvents (e.g., dimethyl sulfoxide (DMSO) and sulfolane), nitrile solvents (e.g., acetonitrile, propionitrile, and acrylonitrile), and organic acid solvents (e.g., formic acid, acetic acid, trichloroacetic acid, and trifluoroacetic acid); and mixtures of these solvents.

Of these solvents, non-polar solvents are preferred, and examples thereof include aromatic hydrocarbon solvents such as xylene, toluene, cyclohexylbenzene, dihydrobenzofuran, trimethylbenzene, and tetramethylbenzene, aromatic heterocyclic compound solvents such as pyridine, pyrazine, furan, pyrrole, thiophene, and methylpyrrolidone, and aliphatic hydrocarbon solvents such as hexane, pentane, heptane, and cyclohexane. Each of these may be used alone or two or more these may be used as a mixture.

The cathode, anode, and inorganic compound layers such as a metal layer and an oxide layer can be formed by a method such as sputtering, vacuum deposition, a sol-gel method, spray pyrolysis deposition (SPD), atomic layer deposition (ALD), vapor deposition, or liquid phase deposition. The anode and the cathode may also be formed by bonding a metal foil. A method suitable for the properties of the material for each layer is preferably selected from these methods, and the layers may be formed by different methods. Of these methods, vapor deposition is more preferred for forming a metal oxide layer. Vapor deposition can form a clean metal oxide layer that is in good contact with the anode without damaging the surfaces of the organic compound layer. As a result, the effects obtained by including a hole injection layer made of a metal as described above become more significant.

When the organic device of the present invention is sealed, a conventional sealing method can be appropriately used in the sealing step. Examples include a method of bonding a sealing container in an inert gas atmosphere and a method of forming a sealing film directly on an organic electroluminescent device. A method of enclosing a moisture absorbing material may be used in combination with any of these methods.

When the organic device is used as an organic electroluminescent device, the device may be a top-emission device in which light is extracted from the side opposite the substrate, or a bottom-emission device in which light is extracted from the substrate side.

The organic device of the present invention can be produced by first producing the thin film-modified electrode of the present invention and then forming layers that constitute the organic device such as an organic layer on the electrode. The present invention also encompasses such a method of producing an organic device, specifically, a method of producing an organic device, including: producing a thin film-modified electrode by the method of producing a thin film-modified electrode of the present invention; and forming an organic layer on the thin film-modified electrode.

The method of producing an organic device of the present invention may include steps in addition to the steps described above. Examples of the additional steps include: forming an inorganic compound layer before or after formation of the organic layer; and forming an inorganic compound layer after formation of the organic layer, followed by forming another organic layer. The formation of an organic layer and the formation of an inorganic compound layer can be performed by the above-described method of forming an organic compound layer that constitutes the organic device and the above-described method of forming an inorganic compound layer, respectively.

### 4. Uses of organic device

The organic device of the present invention is excellent in electron injection properties and air stability, and can be suitably used as an organic electroluminescent device, an organic thin-film solar cell, or a thin-film transistor.

When the organic device of the present invention is used as an organic electroluminescent device, it can be suitably used as a material for a display or a lighting system.

The present invention also encompasses the organic electroluminescent device, organic thin-film solar cell, and thin-film transistor, each including the organic device of the present invention, as well as the display and lighting system, each formed using the organic device of the present invention.

### EXAMPLES

The present invention is described in more detail below with reference to examples, but the present invention is not limited to these examples. Herein, "part(s)" means "part(s) by weight" and "%" means "% by mass" unless otherwise stated.

The compounds used as organic compounds capable of coordinating to a metal are described below.

### (Synthesis Example 1)

A compound represented by the following formula (8) was synthesized by the following method.

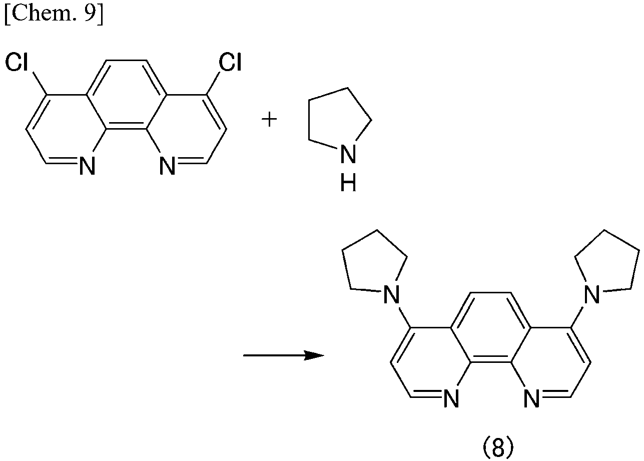

A mixture of 4,7-dichloro-1,10-phenanthroline (3.00 g) and pyrrolidine (19.5 mL) in a 100-mL round-bottom flask was heated under reflux in an oil bath at 100°C for one hour. The mixture was cooled to room temperature and concentrated under reduced pressure. Water was added to the concentrate, and they were subjected to ultrasonication to precipitate a solid, which was collected by filtration. The resulting solid was dried under reduced pressure and dissolved in methanol (100 mL). Activated carbon was added to the mixture, the contents were stirred at room temperature for one hour, and the insoluble matter was separated by filtration. The filtrate was concentrated under reduced pressure to obtain a solid, which was subjected to recrystallization using methanol (9 mL). The resulting solid was rinsed with a small amount of methanol and dried under reduced pressure. Thus, Compound 1 (1.69 g, 44%) represented by the formula (8) was obtained as a white solid.

### (Synthesis Example 2)

Compound 2 represented by the following formula (9) was synthesized using the synthesis method described in WO2012/045179.

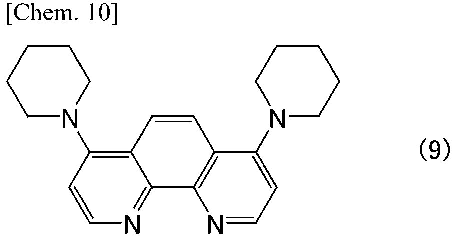

### (Compound 3 and Compound 4)

Compound 3 represented by the following formula (10) and Compound 4 represented by the following formula (11) available respectively from Aldrich and Tokyo Chemical Industry Co., Ltd. were used.

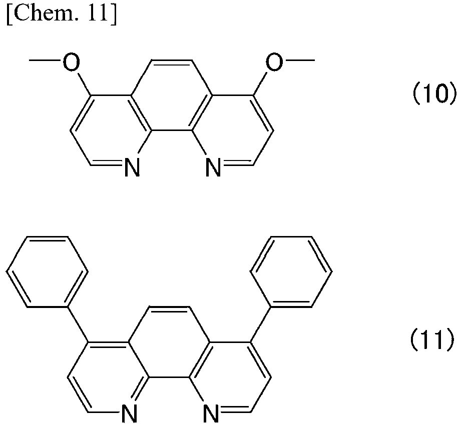

### (Comparative Synthesis Example 1)

Compound 5 represented by the following formula (12) was synthesized using the synthesis method described in WO2012/045179.

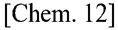

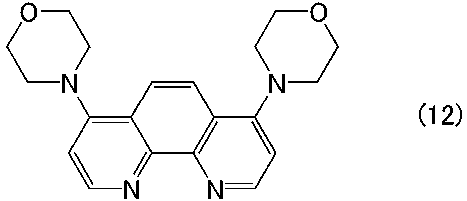

### (Compound 6 and Compound 7)

Compound 6 represented by the following formula (13) and Compound 7 represented by the following formula (14) available respectively from Luminescence Technology Corp. and Tokyo Chemical Industry Co., Ltd. were used.

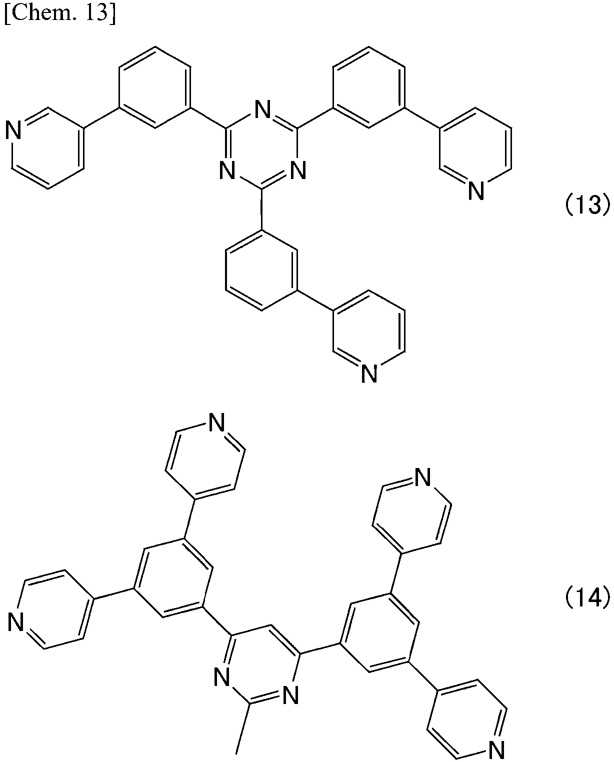

### (Synthesis Example 3)

Compound 8 represented by the following formula (15) was synthesized by the following method.

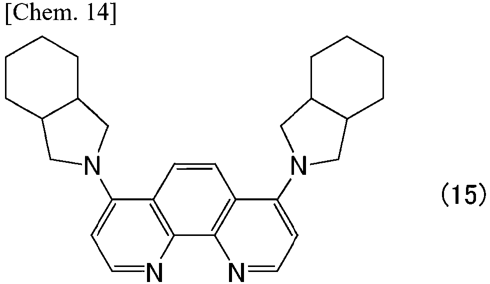

Under an argon atmosphere, a test tube was charged with 1.65 g (6.6 mmol, 1.0 eq.) of 4,7-dichloro-1,10-phenanthroline, 4.98 g (39.7 mmol, 6.0 eq.) of octahydroisoindole, and 7 mL of 2-propanol. The resulting suspension was heated and stirred overnight in an oil bath at 80°C. The suspension was cooled, 4 mL of chloroform and water were added thereto, and the mixture was allowed to stand until it separated into two layers. The resulting organic layer was washed with water by liquid-liquid extraction and concentrated, and then 8 mL of methanol was added to the concentrate. The precipitated white solid was collected by filtration, and the resulting filter cake was rinsed with a small amount of methanol to obtain 2.25 g (2.28 mmol, yield: 80%) of Compound 8.

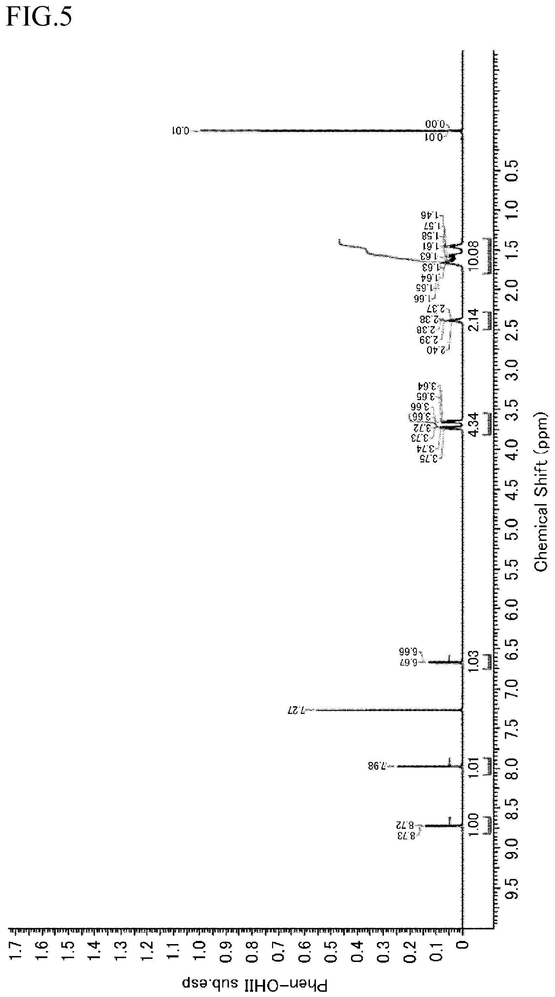

FIG. 5 shows a ¹H-NMR spectrum of Compound 8.

### (Synthesis Example 4)

Compound 9 represented by the following formula (16) was synthesized by the following method.

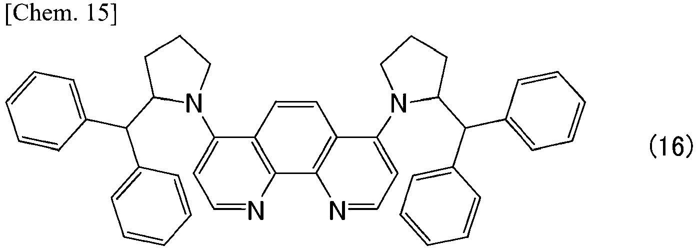

Under an argon atmosphere, a 15-mL pressure-resistant test tube was charged with 0.15 g (0.602 mmol, 1.0 eq.) of 4,7-dichloro-1,10-phenanthroline, 0.571 g (2.41 mmol, 4.0 eq.) of (S)-(-)-2-(diphenylmethyl)pyrrolidine, and 2 mL of degassed N-methylpyrrolidone. The resulting suspension was heated and stirred for six hours in an oil bath at 130°C. The resulting brown suspension was cooled, 5 mL of a 1 N aqueous sodium hydroxide solution was added thereto with vigorous stirring, followed by addition of 4 mL of chloroform, and the suspension was stirred for three minutes and allowed to stand until it separated into two layers. The resulting organic layer was concentrated and the concentrate was purified by a silica gel column to obtain 0.61 g of a pale brown viscous liquid. Then, 8 mL of ethanol was added to the liquid, and they were subjected to ultrasonication until crystals precipitated. The resulting suspension was allowed to stand overnight at 5°C and filtered, and the resulting filter cake was rinsed with a small amount of methanol and vacuum dried at 50°C to obtain 0.11 g (0.169 mmol, yield: 28%) of Compound 9.

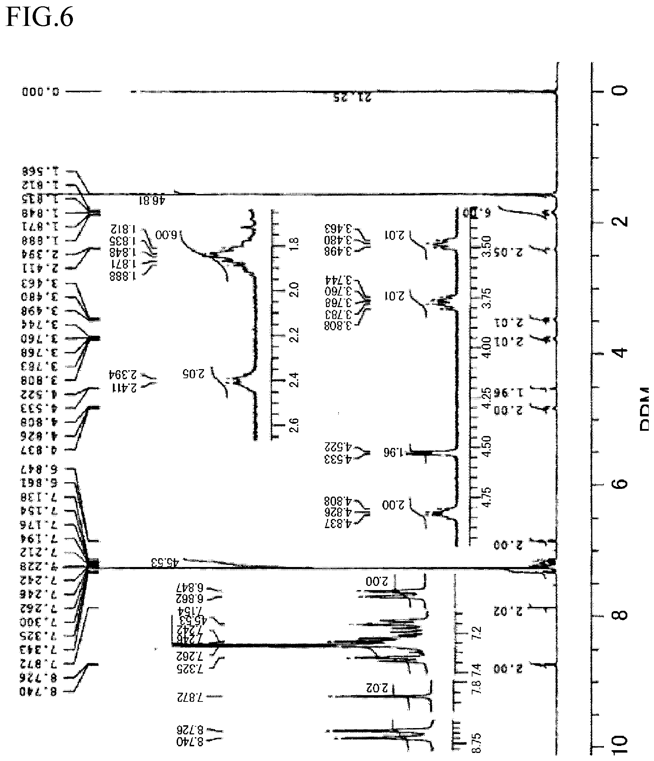

FIG. 6 shows a ¹H-NMR spectrum of Compound 9.

### (Synthesis Example 5)

Compound 10 represented by the following structural formula (17) was synthesized by the following method.

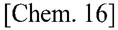

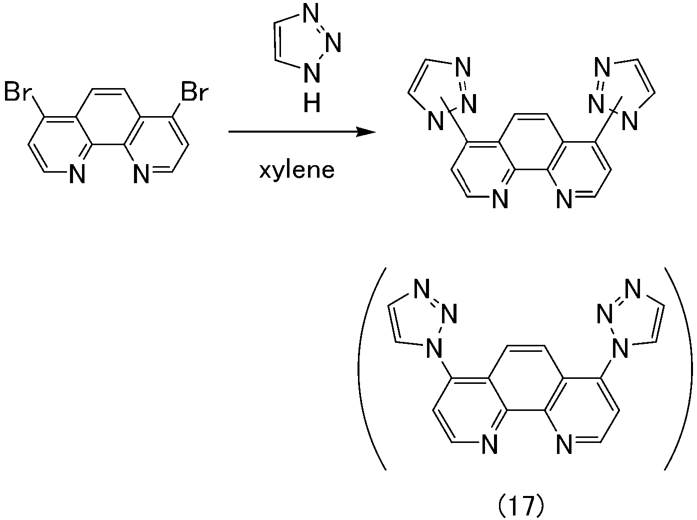

Under an argon atmosphere, a 15-mL reactor was charged with 4,7-dibromo-1,10-phenanthroline (0.6 g, 1.78 mmol, 1.0 eq.), 1,2,3-triazole (0.61 g, 8.88 mmol, 5.0 eq.), and xylene (8 mL). The resulting suspension was heated and stirred for five hours in a bath at 110°C. The resulting brown suspension was cooled and filtered, and the resulting solid was dissolved in THF (20 mL) by heating, followed by addition of toluene (20 mL), and the resulting suspension was purified by column chromatography (NH-SiO₂ = 30 g, toluene/THF = 1/1, followed by chloroform/THF = 10/1) to obtain a light brown solid (0.36 g). The solid was dispersed with heating and rinsed with methanol (10 mL), followed by filtration. The resulting solid was dried at 80°C under high vacuum to obtain Compound 10 (0.32 g, 1.02 mmol, 57%) represented by the structural formula (17) as a light brown solid mixture of isomers.

### (Synthesis Example 6)

Compound 11 represented by the following structural formula (18) was synthesized by the following method.

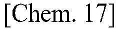

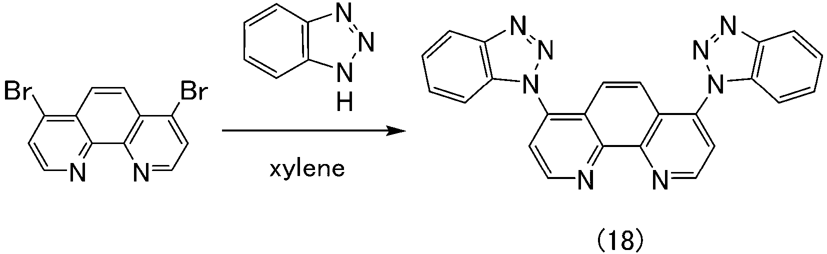

Under an argon atmosphere, a 10-mL pressure-resistant test tube was charged with 4,7-dibromo-1,10-phenanthroline (0.6 g, 1.78 mmol, 1.0 eq.), 1,2,3-benzotriazole (0.70 g, 5.92 mmol, 4.0 eq.), and xylene (8 mL). The resulting suspension was heated and stirred for six hours in a bath at 120°C. The resulting brown suspension was cooled and filtered, the resulting solid was dissolved in chloroform (100 mL) by heating, followed by gel filtration (NH-SiO₂ = 20 g, the gel was rinsed with heated chloroform), and the filtrate was concentrated to obtain a yellow-green solid (0.69 g). The solid was dispersed with heating and rinsed with ethanol (20 mL), followed by filtration. The resulting solid was dried at 80°C under high vacuum to obtain Compound 11 (0.61 g, 1.47 mmol, 99%) represented by the structural formula (18) as a yellow-green solid.

### (Compound 12)

Compound 12 represented by the following structural formula (19) available from Aldrich was used.

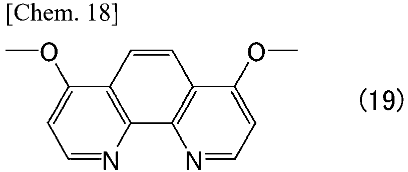

### (Compound 13)

Compound 13 represented by the following structural formula (20) available from Tokyo Chemical Industry Co., Ltd. was used.

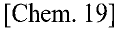

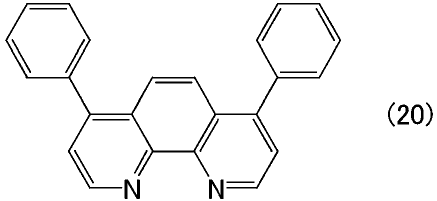

### (Synthesis Example 7)

Compound 14 represented by the following structural formula (21) was synthesized by the following method.

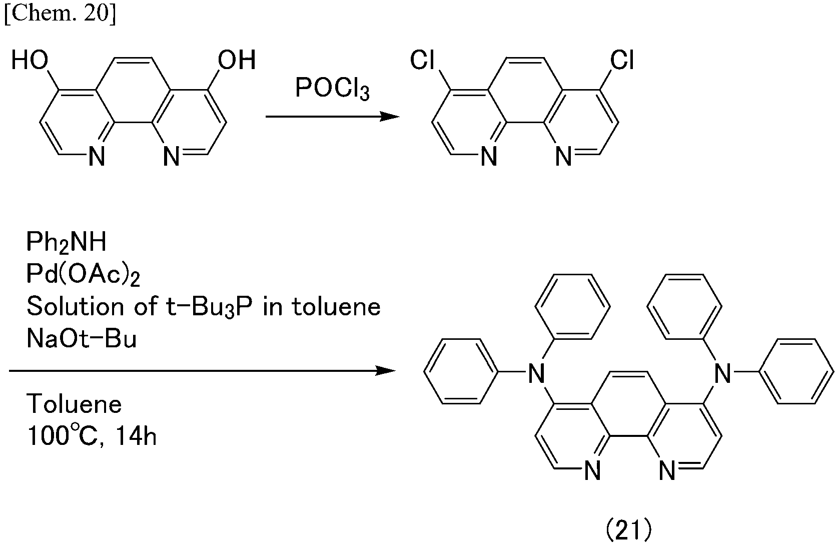

A 200-mL reactor was charged with 4,7-dihydroxy-1,10-phenanthroline (3.83 g, 18.0 mmol, 1.0 eq.) and phosphorus oxychloride (60 mL). The resulting suspension was stirred for three hours in a bath at 130°C. The suspension was cooled and concentrated, and the concentrate was quenched with methanol/distilled water = 1/1 (80 mL) and a 5% aqueous sodium bicarbonate solution. After confirming the completion of neutralization, the mixture was stirred at room temperature for 30 minutes. The precipitate was collected by filtration, and the resulting solid obtained by the filtration was rinsed successively with tap water and methanol and dried under high vacuum at 60°C for eight hours to obtain 4,7-dichloro-1,10-phenanthroline (3.68 g, 15.2 mmol, 84%) as a light beige solid.

Under an argon atmosphere, a 100-mL reactor was charged with 4,7-dichloro-1,10-phenanthroline (0.7 g, 2.81 mmol, 1.0 eq.), diphenylamine (1.9 g, 11.2 mmol, 4.0 eq.), NaOt-Bu (1.08 g, 11.2 mmol, 4.0 eq.), and degassed and dehydrated toluene (20 mL). To the suspension was added a red solution prepared by mixing palladium acetate (21 mg, 0.084 mmol, 0.03 eq.) and t-Bu₃P (0.5 M solution in toluene) (0.67 mL). The suspension was degassed under reduced pressure at room temperature for 15 minutes and heated and stirred for 14 hours in a bath at 100°C. The suspension was cooled to room temperature and filtered through celite, the resulting filter cake was rinsed with toluene (30 mL), and the filtrate was concentrated. The concentrate was purified by column chromatography (SiO₂ = 45 g, chloroform only, followed by chloroform/methanol = 10/1) to obtain a brown solid (1.39 g). The solid was subjected to recrystallization using heated ethanol to obtain Compound 14 (1.13 g, 2.19 mmol, 78%) represented by the structural formula (14) as a pale yellow solid.

### (Synthesis Example 8)

Compound 15 represented by the following structural formula (22) was synthesized using the synthesis method described in WO2012/045179.

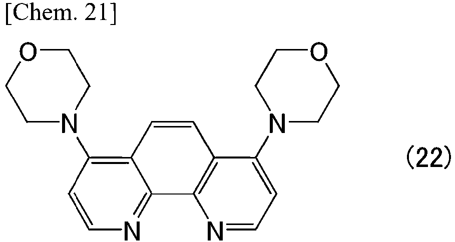

### (Synthesis Example 9)

Compound 16 represented by the following structural formula (23) was synthesized using the synthesis method described in WO2012/045179.

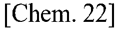

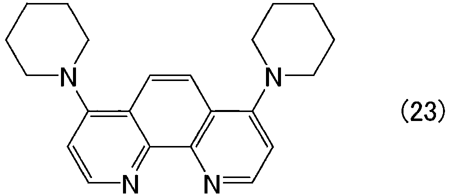

### (Production of organic device)

### (Example 1-1)

(Step 1) A glass substrate 1 with an ITO electrode layer (cathode 2) (thickness 0.7 mm) was prepared. The substrate was subjected to UV ozone cleaning for 20 minutes.

(Step 2) Next, an ultra-thin aluminum metal film 3 having a thickness of 1 nm was formed as follows: the substrate treated in (Step 1) was placed in a vacuum apparatus; and vacuum deposition was performed under a reduced pressure of 5 × 10⁻⁵ Pa or lower.

(Step 3) Next, an electron injection layer 4 was formed by vapor deposition of the material of the formula (8) to a thickness of 3 nm, thereby forming a thin film-modified electrode (2 + 3 + 4).

(Step 4) Next, an electron transport layer 5 was formed by vapor deposition of 1,2-ADN to a thickness of 30 nm.

(Step 5) Thereafter, an emitting layer 6 was formed using 1,2-ADN and BD-1 (dopant material) in a mass ratio of 19:1 to a thickness of 25 nm.

(Step 6) Next, a hole transport layer 7 was formed using Tris-PCz to a thickness of 25 nm.

(Step 7) Subsequently, a hole injection layer 8 was formed using HAT-CN to a thickness of 5 nm.

(Step 8) Finally, a 120 nm-thick anode 9 made of aluminum was formed by vacuum deposition. The anode 9 was formed using a stainless steel deposition mask to obtain a band-shaped deposited area with a width of 3 mm.

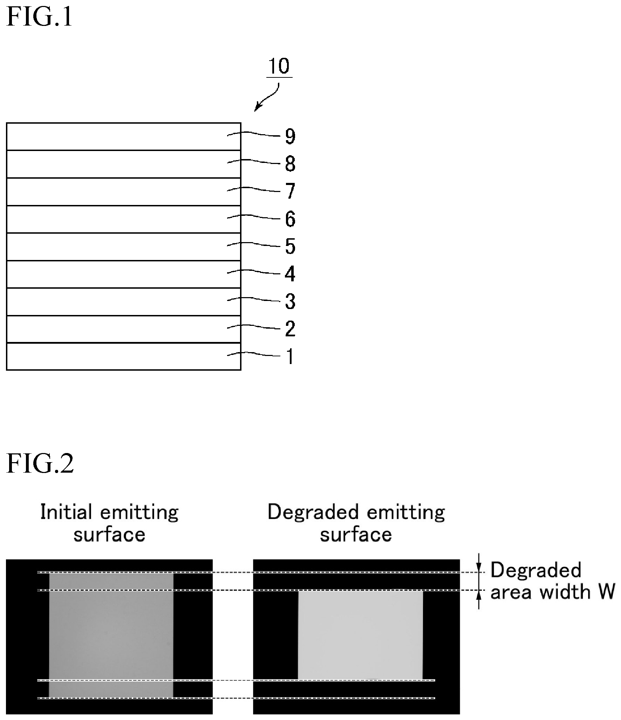

Through (Step 1) to (Step 8), Organic device 1-1 having the structure shown in FIG. 1 was produced.

### (Examples 1-2, 1-3, and 2-1, Comparative Examples 1-1, 1-2, and 2-1)

Organic devices 1-2, 1-3, and 2-1 and Comparative organic devices 1-1, 1-2, and 2-1 were produced as in Example 1-1, except that in (Step 3), the compounds of the formulas (9) to (14) were used instead of the compound of the formula (8).

### (Example 3-1)

The experiment of Example 1-1 was performed again at another time under different measurement conditions including temperature and humidity. Organic device 3-1 was produced through steps as shown in Example 1-1.

### (Examples 3-2 and 3-3)

Organic devices 3-2 and 3-3 were produced as in Example 3-1, except that in (Step 3), the compounds of the formulas (15) and (16) were used instead of the compound of the formula (8).

### (Example 4-1)

Organic device 4-1 was produced as in Example 1-1, except that in (Step 2), magnesium was used instead of aluminum.

### (Examples 4-2 and 4-3 and Comparative Examples 4-1 and 4-2)

Organic devices 4-2 and 4-3 and Comparative organic devices 4-1 and 4-2 were produced as in Example 4-1, except that in (step 3), the compounds of the formulas (9) to (12) were used instead of the compound of the formula (8).

### (Example 5-1)

The experiment of Example 4-1 was performed again at another time under different measurement conditions including temperature and humidity. Organic device 5-1 was produced through steps as shown in Example 4-1.

### (Examples 5-2 and 5-3)

Organic devices 5-2 and 5-3 were produced as in Example 5-1, except that in (Step 3), the compounds of the formulas (15) and (16) were used instead of the compound of the formula (8).

### (Evaluation of air stability)

Organic device 1-1 produced in Example 1-1 was mounted on a measurement apparatus without sealing, under an air atmosphere at room temperature and atmospheric pressure, and stored. The constant current that produced a luminance of 100 nits at the initial measurement was applied every 30 minutes, and images of the emitting surface were captured. The captured images of the emitting surface were subjected to image processing to extract the contour of the emitting surface, and the difference between the extracted contour and the initial contour was calculated to determine the degraded area width w of the emitting surface. The application of a voltage to the organic device, the measurement of the luminance, and the measurement of the average relative humidity were carried out by the following methods.

The relationship between each degraded area width w of the emitting surface shown in FIG. 2 and the elapsed time t from the start of light emission can be approximated to a square root function using the diffusion equation. The degradation (shrinkage) growth rate α was defined as the slope obtained by linear approximation of w² as a function of the elapsed time t (i.e., w² = α^{t} + β), and for Organic device 1-1, the shrinkage growth rate α was calculated from the observation results of the degraded area width w and the elapsed time t from the start of light emission. The shrinkage growth rate α was also determined for Organic devices 1-2 to 5-3 and Comparative organic devices 1-1 to 4-2 as described above. Tables 1 to 5 show the voltage at which the luminance is 100 nit and the shrinkage growth rate α.

### <Measurement of emission characteristics of organic device>

A voltage was applied to the device using Model 2400 SourceMeter available from Keithley Instruments. The luminance was measured using "LS-110" available from Konica Minolta, Inc.

### <Measurement of average relative humidity during storage of device>

A hygrometer was placed in the chamber of the measurement apparatus for evaluation of air stability, and the relative humidity was measured at the time of image capture. The average relative humidity values during the observation of the organic devices are shown in Tables 1 to 5.

### (Molecular orbital calculations)

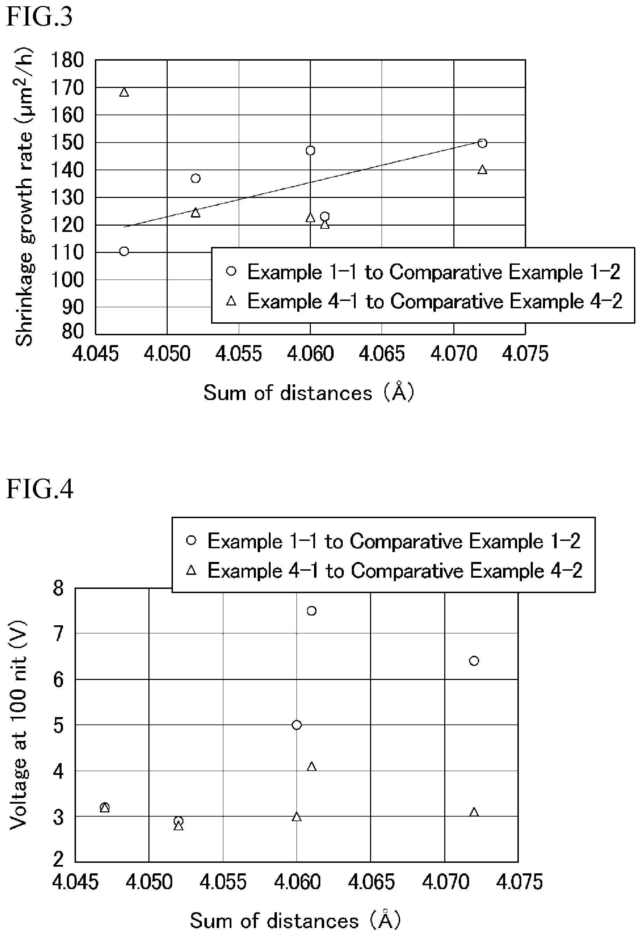

For each of Compounds 1 to 9, the sum of distances from the atoms capable of coordinating to metal in the compound to an aluminum atom was determined from a structure optimized by density functional theory calculations, where the aluminum atom is set as the metal, using functional: B3LYP/basis set: 6-31G**. For Compounds 1 to 5, 8, and 9, the two nitrogen atoms in the phenanthroline skeleton coordinate to the aluminum atom, and therefore the sum of the two N-Al distances was calculated. For Compounds 6 and 7, since the nitrogen atoms in the pyridine skeletons coordinate to the aluminum atom, the sum of the N-Al distances for two pyridine skeletons was calculated. Tables 1 to 5 show the results. FIGS. 3 and 4 show a plot of the relationship between the sum of distances and the shrinkage growth rate α and a plot of the relationship between the sum of distances and the voltage at which the luminance is 100 nits, respectively, for Examples 1-1 to 1-3, Comparative Examples 1-1 and 1-2, Examples 4-1 to 4-3, and Comparative Examples 4-1 and 4-2, in which any of Compounds 1 to 5 is used.

**[Table 1]**

| | Molecular orbital calculations | | Shrinkage growth rate (µm²/h) | Voltage (V) at 100 nit | Average relative humidity (%RH) |
|---|---|---|---|---|---|
| | Organic compound | Sum of distances (Å) from Al to coordinating atom | | | |
| Example 1-1 | Compound 1 | 4.047 | 110.42 | 3.2 | 52.16 |
| Example 1-2 | Compound 2 | 4.052 | 136.91 | 2.9 | 51.79 |
| Example 1-3 | Compound 3 | 4.060 | 147.04 | 5.0 | 51.78 |
| Comparative Example 1-1 | Compound 4 | 4.061 | 123.03 | 7.5 | 52.19 |
| Comparative Example 1-2 | Compound 5 | 4.072 | 149.74 | 6.4 | 51.85 |

**[Table 2]**

| | Molecular orbital calculations | | Shrinkage growth rate (µm²/h) | Voltage (V) at 100 nit | Average relative humidity (%RH) |
|---|---|---|---|---|---|
| | Organic compound | Sum of distances (A) from Al to coordinating atom | | | |
| Example 2-1 | Compound 6 | 3.940 | 124.83 | 9.0 | 52.45 |
| Comparative Example 2-1 | Compound 7 | 4.090 | 197.94 | * | 51.94 |

| | | | | | |
|---|---|---|---|---|---|
| *8.4 V at 1 nit | | | | | |

**[Table 3]**

| | Molecular orbital calculations | | Shrinkage growth rate (µm²/h) | Voltage (V) at 100 nit | Average relative humidity (%RH) |
|---|---|---|---|---|---|
| | Organic compound | Sum of distances (Å) from Al to coordinating atom | | | |
| Example 3-1 | Compound 1 | 4.047 | 19.53 | 3.2 | 25.59 |
| Example 3-2 | Compound 8 | 4.050 | 17.86 | 3.2 | 24.12 |
| Example 3-3 | Compound 9 | 4.049 | 20.02 | 3.5 | 25.58 |

**[Table 4]**

| | Molecular orbital calculations | | Shrinkage growth rate (µm²/h) | Voltage (V) at 100 nit | Average relative humidity (%RH) |
|---|---|---|---|---|---|
| | Organic compound | Sum of distances (Å) from Al to coordinating atom | | | |
| Example 4-1 | Compound 1 | 4.047 | 168.47 | 3.2 | 52.17 |
| Example 4-2 | Compound 2 | 4.052 | 124.57 | 2.8 | 51.79 |
| Example 4-3 | Compound 3 | 4.060 | 122.78 | 3.0 | 51.81 |
| Comparative Example 4-1 | Compound 4 | 4.061 | 120.29 | 4.1 | 52.25 |
| Comparative Example 4-2 | Compound 5 | 4.072 | 140.20 | 3.1 | 51.79 |

**[Table 5]**

| | Molecular orbital calculations | | Shrinkage growth rate (µm²/h) | Voltage (V) at 100 nit | Average relative humidity (%RH) |
|---|---|---|---|---|---|
| | Organic compound | Sum of distances (Å) from Al to coordinating atom | | | |
| Example 5-1 | Compound 1 | 4.047 | 37.01 | 3.2 | 25.56 |
| Example 5-2 | Compound 8 | 4.050 | 31.47 | 3.1 | 24.12 |
| Example 5-3 | Compound 9 | 4.049 | 35.35 | 3.3 | 25.57 |

As shown in Tables 1 and 4 and FIG. 3, there is a correlation between the shrinkage growth rate α and the sum of distances from the atoms capable of coordinating to metal in each compound to an aluminum atom determined by molecular orbital calculations, and a compound with shorter distances from the atoms capable of coordinating to metal in the compound to a metal atom can provide an organic device exhibiting higher resistance to moisture and air and higher air stability.

As shown in Tables 1 and 4 and FIG. 4, there is a correlation between the sum of distances and the voltage at which the luminance is 100 nits, and a compound with shorter distances from the atoms capable of coordinating to metal in the compound to a metal atom can provide an organic device exhibiting higher electron injection properties.

Furthermore, as shown in Table 2, there is a correlation also in compounds different from phenanthroline compounds between the shrinkage growth rate α and the sum of distances from the atoms capable of coordinating to metal in each compound to an aluminum atom determined by molecular orbital calculations.

Furthermore, the results of Tables 1 to 5 demonstrate that a compound having the sum of distances from the atoms capable of coordinating to metal in the compound to an aluminum atom of 4.06 Å or less can provide an organic device independent of external environmental conditions and exhibiting both high air stability and electron injection properties.

### (Example 6)

Organic device 6 having the structure shown in FIG. 1 was produced by the following method and evaluated.

### (Step 1)

A glass substrate 1 with an ITO electrode layer (cathode 2) (thickness 0.7 mm) was prepared. The substrate was subjected to UV ozone cleaning for 20 minutes.

### (Step 2)

Next, a thin aluminum metal film layer 3 having a thickness of 1 nm was formed as follows: the substrate treated in (Step 1) was placed in a vacuum apparatus; and vacuum deposition was performed under a reduced pressure of 5 × 10⁻⁵ Pa or lower.

### (Step 3)

Next, an electron injection layer 4 was formed by vapor deposition of the material of the structural formula (17) to a thickness of 3 nm, thereby forming a thin film-modified electrode (2 + 3 + 4).

### (Step 4)

Next, 1,2-ADN represented by the following structural formula was vapor deposited to a thickness of 30 nm.

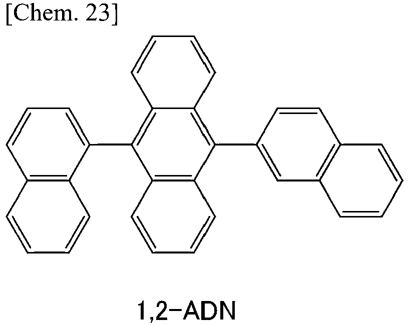

Thereby, an electron transport layer 5 was formed.

### (Step 5)

Thereafter, a light-emitting layer 6 was formed using 1,2-ADN (host material) represented by the above-described structural formula and BD-1 (dopant material) represented by the following structural formula:

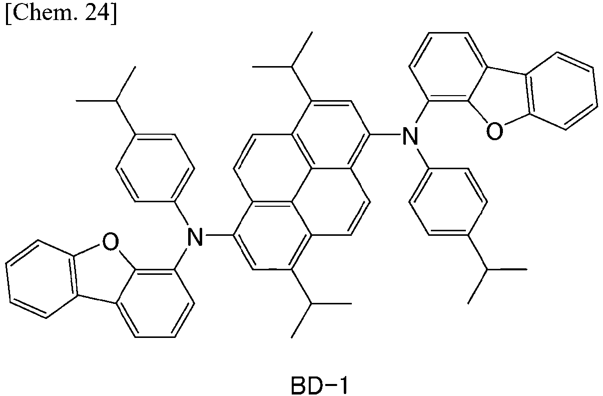

Here, the mass ratio of 1,2-ADN and BD-1 (1,2-ADN:BD-1) was 19:1, and the layer had a thickness of 25 nm.

### (Step 6)

Next, a hole transport layer 7 was formed using Tris-PCz represented by the following structural formula:

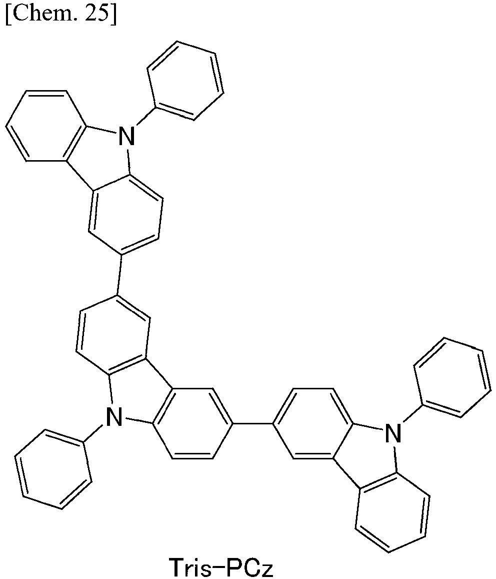

The layer had a thickness of 25 nm.

### (Step 7)

Next, a hole injection layer 8 was formed using HAT-CN represented by the following structural formula:

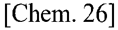

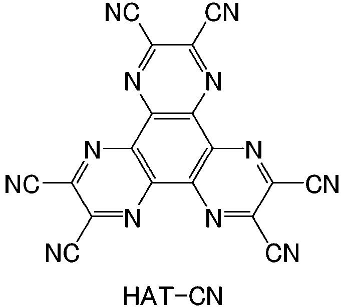

The layer had a thickness of 5 nm.

### (Step 8)

Finally, a 120-nm thick anode 9 made of aluminum was formed by vacuum deposition. The anode 9 was formed using a stainless steel vapor deposition mask to obtain a band-shaped deposited area with a width of 3 mm.

Through (Step 1) to (Step 8), Organic device 6 having the structure shown in FIG. 1 was produced.

### (Examples 7 and 8 and Comparative Examples 5 to 8)

Organic devices of Examples 7 and 8 and Comparative Examples 5 to 8 were produced as in Example 6, except that in (Step 3) above, the compounds of the structural formulas (18) to (23) were used instead of the compound of the structural formula (17).

### (Evaluation of air stability)

Using the same method as in Examples 1-1 to 5-3, the shrinkage growth rate α was determined from the observation results of the degraded area width w and the elapsed time t from the start of light emission for the organic devices of Examples 6 to 8 and Comparative Examples 5 to 8. Table 6 shows the shrinkage growth rate α.

### (Optimization by molecular orbital calculations and molecular dynamics calculations)

The three-dimensional structures of the compounds represented by the structural formulas (17) to (23) were optimized by density functional theory calculations using functional: B3LYP-D3/basis set: 6-31G**. The optimized molecular structures were expanded to an amorphous system of 128 molecules, and molecular dynamics calculations were performed under isobaric and isothermal conditions of 1.2 ns, 300 K, and 1.01325 bar. The calculations balance the contributions of intermolecular bonding and non-bonding energies, and finally yields a converged density. Table 6 shows the results.

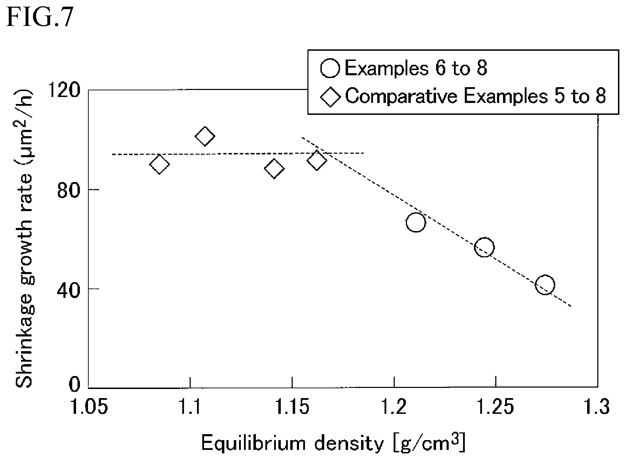

FIG. 7 is a plotted graph showing the relationship between the equilibrium density and the shrinkage growth rate α for the organic devices of Examples 6 to 8 and Comparative Examples 5 to 8, in which the compounds represented by the structural formulas (17) to (23) are used.

**[Table 6]**

| | Organic compound | | Shrinkage growth rate (µm²/h) |
|---|---|---|---|
| | Structural formula | Equilibrium density [g/cm]³ | |
| Example 6 | Structural formula (17) | 1.274 | 41.043 |
| Example 7 | Structural formula (18) | 1.244 | 56.268 |
| Example 8 | Structural formula (19) | 1.211 | 66.501 |
| Comparative Example 5 | Structural formula (20) | 1.141 | 87.944 |
| Comparative Example 6 | Structural formula (21) | 1.107 | 100.905 |
| Comparative Example 7 | Structural formula (22) | 1.162 | 91.350 |
| Comparative Example 8 | Structural formula (23) | 1.085 | 89.590 |

As shown in Table 6 and FIG. 7, there is a relationship shown by the dotted lines in the figure between the calculated equilibrium density of each compound and the shrinkage growth rate α, and a compound having a higher equilibrium density can provide an organic device exhibiting higher resistance to moisture and air and higher air stability.

### INDUSTRIAL APPLICABILITY

The thin film-modified electrode of the present invention and the organic device including the thin film-modified electrode of the present invention can be suitably used as an organic electroluminescent device, an organic thin-film solar cell, an organic thin-film transistor, etc.

### REFERENCE SIGNS LIST

1: substrate
2: cathode
3: thin film metal layer
4: electron injection layer
5: electron transport layer
6: emitting layer
7: hole transport layer
8: hole injection layer
9: anode
10: organic device

## Claims

1. A thin film-modified electrode comprising:
an electrode; and
a layer containing at least one metal and an organic compound capable of coordinating to the at least one metal, the layer being in contact with the electrode, or
both a layer containing at least one metal, the layer being in contact with the electrode, and a layer containing an organic compound capable of coordinating to the at least one metal, the layer being in contact with the layer containing at least one metal,
the organic compound being a compound containing atoms capable of coordinating to metal and having a sum of distances from the atoms capable of coordinating to metal in the organic compound to an aluminum atom of 4.06 Å or less, as determined from a structure optimized by density functional theory calculations, where the aluminum atom is set as the metal, using functional: B3LYP/basis set: 6-31G**.

2. The thin film-modified electrode according to claim 1,
wherein the at least one metal comprises a metal having a work function of 4.0 eV or higher.

3. A thin film-modified electrode comprising:
an electrode; and
a layer containing at least one metal and an organic compound capable of coordinating to the at least one metal, the layer being in contact with the electrode, or
both a layer containing at least one metal, the layer being in contact with the electrode, and a layer containing an organic compound capable of coordinating to the at least one metal, the layer being in contact with the layer containing at least one metal,
the organic compound being a compound having an equilibrium density of intermolecular packing of 1.17 g/cm³ or more, as determined by molecular dynamics calculations from a structure optimized by density functional theory calculations using functional: B3LYP-D3/basis set: 6-31G**.

4. The thin film-modified electrode according to claim 3,
wherein the equilibrium density of the organic compound is 1.20 g/cm³ or more.

5. The thin film-modified electrode according to any one of claims 1 to 4,
wherein the at least one metal is at least one selected from the group consisting of aluminum, magnesium, and silver.

6. The thin film-modified electrode according to any one of claims 1 to 5,
wherein the atoms capable of coordinating to metal in the organic compound are selected from the group consisting of a nitrogen atom, a sulfur atom, and an oxygen atom.

7. An organic device comprising the thin film-modified electrode according to any one of claims 1 to 6.

8. A lighting system comprising the organic device according to claim 7.

9. A display comprising the organic device according to claim 7.

10. A method of producing a thin film-modified electrode, comprising:
a first step of selecting an organic compound capable of coordinating to a metal, the organic compound containing atoms capable of coordinating to metal and having a sum of distances from the atoms capable of coordinating to metal in the organic compound to an aluminum atom of 4.06 Å or less, as determined from a structure optimized for the organic compound by density functional theory calculations, where the aluminum atom is set as the metal, using functional: B3LYP/basis set: 6-31G**; and
a second step including forming, using the organic compound selected in the first step and a metal, a layer containing the organic compound and the metal, the layer being in contact with an electrode, or forming sequentially a layer containing the metal, the layer being in contact with an electrode, and a layer containing the organic compound, the layer being in contact with the layer containing the metal.

11. A method of producing a thin film-modified electrode, comprising:
a first step of selecting an organic compound capable of coordinating to a metal, the organic compound having an equilibrium density of intermolecular packing of 1.17 g/cm³ or more, as determined by molecular dynamics calculations from a structure optimized for the organic compound by density functional theory calculations using functional: B3LYP-D3/basis set: 6-31G**; and
a second step including forming, using the organic compound selected in the first step and a metal, a layer containing the organic compound and the metal, the layer being in contact with an electrode, or forming sequentially a layer containing the metal, the layer being in contact with an electrode, and a layer containing the organic compound, the layer being in contact with the layer containing the metal.

12. A method of producing an organic device, comprising:
producing a thin film-modified electrode by the method of producing a thin film-modified electrode according to claim 10 or 11; and
forming an organic layer on the thin film-modified electrode.

13. A method of selecting an organic compound suitable as a material used in combination with a metal to form an electron injection layer of an organic device,
the method comprising selecting, as the material used in combination with a metal to form an electron injection layer of an organic device, an organic compound capable of coordinating to the metal, the organic compound containing atoms capable of coordinating to metal and having a sum of distances from the atoms capable of coordinating to metal in the organic compound to an aluminum atom of 4.06 Å or less, as determined from a structure optimized for the organic compound by density functional theory calculations, where the aluminum atom is set as the metal, using functional: B3LYP/basis set: 6-31G**.

14. A method of selecting an organic compound suitable as a material used in combination with a metal to form an electron injection layer of an organic device,
the method comprising selecting, as the material used in combination with a metal to form an electron injection layer of an organic device, an organic compound capable of coordinating to the metal, the organic compound having an equilibrium density of intermolecular packing of 1.17 g/cm³ or more, as determined by molecular dynamics calculations from a structure optimized for the organic compound by density functional theory calculations using functional: B3LYP-D3/basis set: 6-31G**.
